(19) **Europäisches Patentamt / European Patent Office / Office européen des brevets**

(11) **EP 4 571 333 A1**

(12) **EUROPEAN PATENT APPLICATION**
published in accordance with Art. 153(4) EPC

(43) Date of publication:
**18.06.2025 Bulletin 2025/25**

(21) Application number: **23868652.1**

(22) Date of filing: **22.09.2023**

(51) International Patent Classification (IPC):
*G01R 31/36* (2020.01)       *G01R 31/392* (2019.01)
*G01R 31/385* (2019.01)     *G01R 31/396* (2019.01)
*G01R 19/00* (2006.01)       *G01R 19/30* (2006.01)
*G01R 19/10* (2006.01)       *B60L 58/10* (2019.01)
*G01R 31/3835* (2019.01)

(52) Cooperative Patent Classification (CPC):
**B60L 58/10; G01R 19/00; G01R 19/10;
G01R 19/30; G01R 31/36; G01R 31/3835;
G01R 31/385; G01R 31/392; G01R 31/396;**
Y02E 60/10

(86) International application number:
**PCT/KR2023/014493**

(87) International publication number:
**WO 2024/063600 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.09.2022   KR 20220120366
04.05.2023   KR 20230058253
21.09.2023   KR 20230126472**

(71) Applicant: **LG Energy Solution, Ltd.
Seoul 07335 (KR)**

(72) Inventors:
• **SUNG, Yong Chul**
  **Daejeon 34122 (KR)**
• **KIM, Cheol Taek**
  **Daejeon 34122 (KR)**
• **KIM, Chang Hoon**
  **Daejeon 34122 (KR)**
• **PARK, Hee Ju**
  **Daejeon 34122 (KR)**

(74) Representative: **Plasseraud IP
104 Rue de Richelieu
CS92104
75080 Paris Cedex 02 (FR)**

(54) **BATTERY MANAGEMENT DEVICE AND OPERATION METHOD THEREFOR**

(57)    A battery management system includes a voltage measurement unit that measures a voltage of each of a plurality of batteries; and a controller. The controller controls the voltage measurement unit to measure the voltage of each of the plurality of batteries; calculates a first deviation, which is a deviation between long-term and short-term moving average values of the voltage of each of the plurality of batteries; calculates a second deviation, which is a deviation between long-term and short-term moving average values of an average voltage of the plurality of batteries; calculates a first diagnosis deviation, which is a difference between the first and second deviations; calculates a second diagnosis deviation based on a reference value obtained by multiplying the second deviation by a threshold constant; and based on the second diagnosis deviation, diagnoses an abnormality of at least one battery among the plurality of batteries.

EP 4 571 333 A1

200    220

VOLTAGE
MEASUREMENT
UNIT
210

ARITHMETIC
OPERATION UNIT
230

DIAGNOSIS UNIT
240

CONTROL UNIT
250

FIG.2

**Description**

**[TECHNICAL FIELD]**

CROSS-REFERENCE TO RELATED APPLICATIONS

This application is based on and claims priorities from Korean Patent Application Nos. 10-2022-0120366, 10-2023-0058253, and 10-2023-0126472, filed on September 22, 2022, May 4, 2023, and September 21, 2023, respectively, with the Korean Intellectual Property Office, all of which are incorporated herein in their entireties by reference.

TECHNICAL FIELD

The present disclosure relates to a battery management system, and an operation method thereof.

**[BACKGROUND ART]**

Electric vehicles draw their vitality from external power sources to replenish their battery cells, infusing them with the energy required for driving power. As these battery cells undergo the cycles of charge and discharge throughout their stages of manufacturing and use, internal deformation and degeneration will take place. Consequently, this process can alter their physical and chemical properties, potentially resulting in defects such as internal short, external short, venting caused from lithium deposits, and undervoltage faults where the battery cell voltage drops below a certain threshold.

An internal fault of a battery cell may result in adverse effects directly on the battery cell, including deterioration of performance of the battery cell and electrolyte leakage which leads to potential ignition.

**[DISCLOSURE]**

**[TECHNICAL PROBLEM]**

An object of embodiments of the present disclosure is to provide a battery management system and an operation method thereof, which can accurately diagnose an abnormal battery cell by removing noise of a deviation between long-term and short-term moving average values of a voltage of a battery cell.

The object of the embodiments of the present disclosure is not limited to that described above, and other objects that are not described herein may clearly be understood by those skilled in the art from the descriptions herein below.

**[TECHNICAL SOLUTION]**

According to an embodiment of the present disclosure, a battery management system includes: a voltage measurement unit that measures a voltage of each of a plurality of batteries; and a controller in communication with the voltage measurement unit and that controls an overall operation of the battery management system. The controller controls the voltage measurement unit to measure the voltage of each of the plurality of batteries at predetermined time intervals; calculates a first deviation, which is a deviation between a long-term moving average value and a short-term moving average value of the voltage of each of the plurality of batteries; calculates a second deviation, which is a deviation between a long-term moving average value and a short-term moving average value of an average voltage of the plurality of batteries; calculates a first diagnosis deviation, which is a difference between the first deviation and the second deviation, for each of the plurality of batteries; calculates a second diagnosis deviation for each of the plurality of batteries by removing noise of the first diagnosis deviation of each of the plurality of batteries based on a reference value of the first diagnosis deviations of the first diagnosis deviations of each of the plurality of batteries obtained by multiplying the second deviation by a threshold constant; and based on the second diagnosis deviation of each of the plurality of batteries, diagnoses an abnormality of at least one battery among the plurality of batteries.

In an embodiment, the controller may set the reference value to a maximum value between a value obtained by multiplying the second deviation by a first threshold constant, and a second threshold constant, and calculate the second diagnosis deviation of each of the plurality of batteries by excluding the first diagnosis deviation of each of the plurality of batteries when the first diagnosis deviation is equal to or less than the reference value.

In an embodiment, the controller may calculate a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant.

In an embodiment, the controller may calculate a skewness for each of the plurality of batteries by adding a minimum value of the third diagnosis deviation of each of the plurality of batteries to the third diagnosis deviation of each of the plurality of batteries, and dividing an obtained value by the third diagnosis deviation.

In an embodiment, the controller may calculate a fourth diagnosis deviation for each of the plurality of batteries by multiplying the third diagnosis deviation of each of the plurality of batteries by the skewness.

In an embodiment, the controller may diagnose an abnormality of at least one battery among the plurality of batteries based on whether the fourth diagnosis deviation of each of the plurality of batteries exceeds a threshold value.

In an embodiment, the controller may calculate a plurality of first deviations and a plurality of second deviations at unit time intervals to calculate the fourth diagnosis deviation of each of the plurality of batteries, and when the fourth diagnosis deviation of at least one battery of the plurality of batteries exceeds the threshold value, the controller diagnoses the at least one battery as an abnormal battery.

According to another embodiment of the present disclosure, a method for operating a battery management system includes: causing a voltage measurement unit to measure a voltage of each of a plurality of batteries at predetermined time intervals; calculating a first deviation, which is a deviation between a long-term moving average value and a short-term moving average value of the voltage of each of the plurality of batteries; calculating a second deviation, which is a deviation between a long-term moving average value and a short-term moving average value of an average voltage of the plurality of batteries; calculating a first diagnosis deviation, which is a difference between the first deviation and the second deviation, for each of the plurality of batteries; calculating a second diagnosis deviation for each of the plurality of batteries based on a reference value of the first diagnosis deviations of the first diagnosis deviations of each of the plurality of batteries obtained by multiplying the second deviation by a threshold constant; and based on the second diagnosis deviation of each of the plurality of batteries, diagnosing an abnormality of at least one battery among the plurality of batteries.

In an embodiment, the calculating the second diagnosis deviation may include setting the reference value to a maximum value between a value obtained by multiplying the second deviation by a first threshold constant, and a second threshold constant, and calculating the second diagnosis deviation of each of the plurality of batteries by excluding the first diagnosis deviation of each of the plurality of batteries when the first diagnosis deviation is equal to or less than the reference value.

In an embodiment, the calculating the second diagnosis deviation may include calculating a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant.

In an embodiment, the calculating the second diagnosis deviation may include calculating a skewness for each of the plurality of batteries by adding a minimum value of the third diagnosis deviation of each of the plurality of batteries to the third diagnosis deviation of each of the plurality of batteries, and dividing an obtained value by the third diagnosis deviation.

In an embodiment, the calculating the second diagnosis deviation may include calculating a fourth diagnosis deviation for each of the plurality of batteries by multiplying the third diagnosis deviation of each of the plurality of batteries by the skewness.

In an embodiment, the diagnosing an abnormality of at least one battery may include diagnosing an abnormality of at least one battery among the plurality of batteries based on whether the fourth diagnosis deviation of each of the plurality of batteries exceeds a threshold value.

In an embodiment, the diagnosing an abnormality of at least one battery may include calculating a plurality of first deviations and a plurality of second deviations at unit time intervals to calculate the fourth diagnosis deviation of each of the plurality of batteries, and when the fourth diagnosis deviation of at least one battery of the plurality of batteries exceeds the threshold value, diagnosing the at least one battery as an abnormal battery.

According to an embodiment of the present disclosure, a controller includes: a memory, and a processor coupled to the memory and configured to execute the operating method of battery management apparatus recited in the claim 8.

In an embodiment, in the operating method of battery management apparatus, the calculating the second diagnosis deviation may include setting the reference value to a maximum value between a value obtained by multiplying the second deviation by a first threshold constant, and a second threshold constant, calculating the second diagnosis deviation of each of the plurality of batteries by excluding the first diagnosis deviation of each of the plurality of batteries when the first diagnosis deviation is equal to or less than the reference value, calculating a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant, calculating a skewness for each of the plurality of batteries by adding a minimum value of the third diagnosis deviation of each of the plurality of batteries to the third diagnosis deviation of each of the plurality of batteries, and dividing an obtained value by the third diagnosis deviation, and calculating a fourth diagnosis deviation for each of the plurality of batteries by multiplying the third diagnosis deviation of each of the plurality of batteries by the skewness, the diagnosing an abnormality of at least one battery includes diagnosing an abnormality of at least one battery among the plurality of batteries based on whether the fourth diagnosis deviation of each of the plurality of batteries exceeds a threshold value.

According to an embodiment of the present disclosure, a non-transitory computer-readable storage medium having stored therein a program that causes an information processing apparatus to execute a process including: measuring a voltage of each of a plurality of batteries at predetermined time intervals using a voltmeter, calculating a first deviation, which is a deviation between a long-term moving average value and a short-term moving average value of the voltage of each of the plurality of batteries, calculating a second deviation, which is a deviation between a long-term moving average value and a short-term moving average value of an average voltage of the plurality of batteries, calculating a first diagnosis deviation, which is a difference between the first deviation and the second deviation, for each of the plurality of batteries, calculating a second diagnosis deviation for each of the plurality of batteries based on a reference value of the first diagnosis deviations of the first diagnosis deviations of each of the plurality of batteries obtained by multiplying the second deviation by a threshold constant, and based on the second diagnosis deviation of each of the plurality of batteries, diagnosing an abnormality of at least one battery among the plurality of batteries.

In an embodiment, , the calculating the second diagnosis deviation may include setting the reference value to a maximum value between a value obtained by multiplying the second deviation by a first threshold constant, and a second threshold constant, calculating the second diagnosis deviation of each of the plurality of batteries by excluding the first diagnosis deviation of each of the plurality of batteries when the first diagnosis deviation is equal to or less than the reference value, calculating a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant, calculating a skewness for each of the plurality of batteries by adding a minimum value of the third diagnosis deviation of each of the plurality of batteries to the third diagnosis deviation of each of the plurality of batteries, and dividing an obtained value by the third diagnosis deviation, and calculating a fourth diagnosis deviation for each of the plurality of batteries by multiplying the third diagnosis deviation of each of the plurality of batteries by the skewness, the diagnosing an abnormality of at least one battery includes diagnosing an abnormality of at least one battery among the plurality of batteries based on whether the fourth diagnosis deviation of each of the plurality of batteries exceeds a threshold value.

[EFFECT OF THE INVENTION]

According to a battery management system and an operation method thereof according to embodiments of the present disclosure, it is possible to accurately diagnose an abnormal battery cell by removing noise of a deviation between long-term and short-term moving average values of a voltage of a battery cell.

[BRIEF DESCRIPTION OF THE DRAWINGS]

FIG. 1 is a view illustrating a battery pack according to an embodiment of the present disclosure.
FIG. 2 is a block diagram illustrating a configuration of a battery management system according to an embodiment of the present disclosure.
FIG. 3 is a flowchart illustrating an operation method of the battery management system according to an embodiment of the present disclosure.
FIG. 4 is a graph illustrating a voltage variation of each battery cell according to an embodiment of the present disclosure.
FIG. 5A is a graph illustrating a first diagnosis deviation of each battery cell according to an embodiment of the present disclosure.
FIG. 5B is a graph illustrating a third diagnosis deviation of each battery cell according to an embodiment of the present disclosure.
FIG. 5C is a graph illustrating the skewness of the third diagnosis deviation of a battery cell according to an embodiment of the present disclosure.
FIG. 5D is a graph illustrating a fourth diagnosis deviation of a battery cell according to an embodiment of the present disclosure.
FIG. 6 is a flowchart illustrating an operation method of a battery management system according to another embodiment of the present disclosure.
FIG. 7 is a flowchart illustrating an operation method of a battery management system and a method of diagnosing an abnormal battery cell according to yet another embodiment of the present disclosure.
FIG. 8A is a graph illustrating a first voltage of each battery cell during discharge and relaxation time after discharge according to another embodiment of the present disclosure.

FIG. 8B is a graph illustrating a first voltage of each battery cell during charge and relaxation time after charge according to another embodiment of the present disclosure.

FIG. 9A is a graph illustrating a long-term moving average (solid line) and a short-term moving average (dashed line) of the first voltage of each battery cell during discharge and relaxation time after discharge according to another embodiment of the present disclosure.

FIG. 9B is a graph illustrating a long-term moving average (solid line) and a short-term moving average (dashed line) of the first voltage of each battery cell during charge and relaxation time after the charge according to another embodiment of the present disclosure.

FIG. 10A is a graph illustrating a first deviation (dV) of the first voltage of each battery cell during discharge and relaxation time after the discharge according to an embodiment of the present disclosure.

FIG. 10B is a graph illustrating a first deviation (dV) of the first voltage of each battery cell during charge and relaxation time after charge according to another embodiment of the present disclosure.

FIG. 11A is a graph illustrating a first diagnosis deviation (D1) of each battery cell during discharge and relaxation time after discharge according to another embodiment of the present disclosure.

FIG. 11B is a graph illustrating a first diagnosis deviation (D1) of each battery cell during charge and relaxation time after charge according to another embodiment of the present disclosure.

FIG. 12 is a flowchart illustrating an operation method of a battery management system and a method of diagnosing an abnormal battery cell according to yet another embodiment of the present disclosure.

FIG. 13 is a block diagram illustrating a hardware configuration of a computing system that implements an operation method of a battery management system according to an embodiment of the present disclosure.

## [MODE FOR INVENTION]

Hereinafter, non-limiting examples of embodiments of the present disclosure will be described in detail with reference to the drawings. It is noted that the same components will be denoted by the same reference numerals even though they are illustrated in different drawings. When describing the embodiments herein, detailed description of related well-known configuration or a function thereof may be omitted if determined to impede the understanding of the embodiments.

In order to describe components of the embodiments, for example, terms such as "first," "second," "A," "B," "(a)," and "(b)" may be used. These terms are intended to simply discriminate a component from another without limiting the nature, sequence, or order of the component. Further, unless otherwise defined, all terms used herein, including technical and scientific terminologies, have the same meaning as commonly understood by those skilled in the art to which the embodiments of the present disclosure pertain. Terms such as those defined in commonly used dictionaries should be interpreted as having a meaning that is consistent with their meaning in the context of the relevant art, and should not be interpreted in an ideal or excessively formal sense unless clearly defined herein.

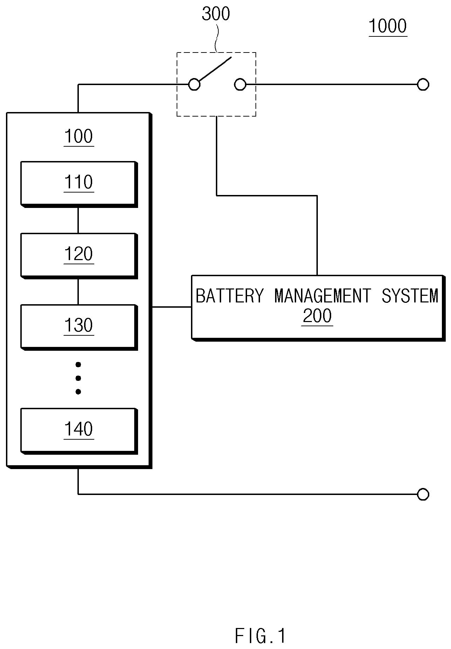

FIG. 1 is a view illustrating a battery pack according to an embodiment of the present disclosure. According to an embodiment of the present disclosure, a battery pack 1000 may include a battery module 100, a battery management system 200 (hereinafter, the "BMS 200"), and a relay 300. According to various embodiments, the battery module 100 may be battery cells. For example, the battery pack 1000 may have a cell-to-pack structure, in which battery cells are directly assembled into a pack without being divided into individual modules. This is unlike an existing battery, in which modules each consisting of battery cells are packaged.

While FIG. 1 illustrates one battery module 100, the battery pack 1000 may be configured with a plurality of battery modules 100 and may have a stacked structure of the plurality of battery modules 100, according to embodiments. The battery module 100 may include a plurality of battery cells 110, 120, 130, and 140 (hereinafter, the "battery cells 110 to 140"). While FIG. 1 illustrates four battery cells, the number of battery cells is not limited thereto. The battery module 100 may include "n" battery cells ("n" is a natural number equal to or more than one). Further, each of the battery cells 110 to 140 may be configured with two or more battery cells connected in parallel to form a battery group or a battery bank.

The battery module 100 may supply power to a target apparatus (not illustrated). To this end, the battery module 100 may be electrically connected to the target apparatus. Here, the target apparatus may include an electrical, electronic, or mechanical apparatus that operates by receiving power from the battery pack 1000 including the battery cells 110 to 140. For example, the target apparatus may be an electric vehicle (EV) or an energy storage system (ESS), but is not limited thereto.

Each of the battery cells 110 to 140 is a basic unit of a battery that can be used by charging/discharging electrical energy, and may be, for example, but is not limited to, a lithium-ion (Li-ion) cell, a lithium-ion polymer (Li-ion polymer) cell, a nickel-cadmium (Ni-Cd) cell, or a nickel-hydride (Ni-MH) cell. While FIG. 1 illustrates one battery module 100, a plurality of battery modules 100 may be provided according to embodiments.

The BMS 200 may manage and/or control the state and/or operation of the battery module 100. For example, the BMS 200 may manage and/or control the state and/or operation of the battery cells 110 to 140 included in the battery module 100, and may manage the charge and/or discharge of the battery module 100.

Further, the BMS 200 may control the operation of the relay 300. For example, the BMS 200 may short-circuit the relay 300 in order to supply power to the target apparatus, and may also short-circuit the relay 300 when a charger is connected to the battery pack 1000.

The BMS 200 may monitor, for example, the voltage, current, and temperature of the battery module 100 and/or each of the battery cells 110 to 140 included in the battery module 100. For the monitoring by the BMS 200, sensors (not illustrated) or various measurement modules (not illustrated) may be additionally installed, for example, at arbitrary positions in the battery module 100 or charge/discharge pathways. The BMS 200 may calculate the parameters indicating the state of the battery module 100, such as a state of charge (SOC) or a state of health (SOH), based on measured values of the monitored voltage, current, temperature and others.

The battery cells 110 to 140 typically go through changes in various factors over time and through repeated usages, such as decrease in capacity and increase in internal resistance, resulting in abnormalities in the batteries. Thus, a technology for diagnosing an abnormality in battery cells is necessary. Based on data of the various factors that change as the battery cells age, the BMS 200 serves to diagnose internal abnormalities in the battery cells 110 to 140.

Battery cell faults may occur for various reasons such as, for example, defects in the manufacturing stage, internal deformation and degeneration through repeated charge/discharge, or external shock. In a battery cell with these faults, a faster and more significant voltage variation occurs as compared to normal battery cells. While utilizing the phenomenon that the battery cell with the internal fault exhibits the faster and more significant voltage variation during a relaxation time than normal battery cells, the BMS 200 may compare the voltage data of each of the battery cells 110 to 140 during the relaxation time with statistical normal voltage data of a normal battery cell during the relaxation time, and diagnose an abnormal battery cell among the battery cells 110 to 140. The relaxation time of a battery cell or module refers to a state where the battery cell or module is not being currently charged or discharged, or is not electrically connected to a load. For example, the BMS 200 may monitor voltage values of cells or a charge/discharge current value of a battery module, to determine whether the battery cell or module is in the relaxation state. Herein, the diagnosis of an abnormal battery cell during the relaxation time will be described. However, the method of diagnosing an abnormal battery cell according to embodiments of the present disclosure is not limited to the diagnosis during the relaxation time, and may also be performed for other periods such as charge or discharge of a battery cell or module.

The voltage of an abnormal battery cell declines, for example, during the relaxation time after charge in comparison to normal battery cells, which causes a significant deviation in the voltage behavior of the abnormal battery cell as compared to voltage behaviors of normal battery cells. Consequently, the voltage behavior of the abnormal battery cell is skewed to one side and has a relatively large skewness (skew or asymmetry). While utilizing the characteristic that an abnormal battery cell has relatively large deviation and skewness in voltage behavior as compared to normal battery cells, the BMS 200 according to an embodiment of the present disclosure may determine the presence of an abnormal battery cell among the battery cells 110 to 140.

The BMS 200 may calculate a deviation dV between an average value of the voltages of the battery cells 110 to 140 and the voltage of each of the battery cells 110 to 140 at a predetermined time. Based on the deviation between the average value of the voltages of the battery cells 110 to 140 and the voltage of each of the battery cells 110 to 140, the BMS 200 may determine an abnormal voltage behavior of at least one battery cell among the battery cells 110 to 140 and diagnose the abnormality of the battery cell.

Further, the BMS 200 may diagnose an abnormal battery cell using the voltage deviation data of each of the battery cells 110 to 140 while excluding potential noise data of the voltage deviation data of each of the battery cells 110 to 140. After excluding the noise data of the voltage deviation data of each of the battery cells 110 to 140, the BMS 200 may amplify the voltage deviation data of each of the battery cells 110 to 140. With the amplified voltage deviation data of each of the battery cells 110 to 140, the BMS 200 may detect and diagnose an abnormal battery cell suspected of having an abnormal voltage.

The operation of the BMS 200 described herein below may be performed in various devices, such as a server, cloud, charger, or charger-discharger connected to the BMS 200 or a vehicle equipped with the BMS 200, through wired or wireless signals.

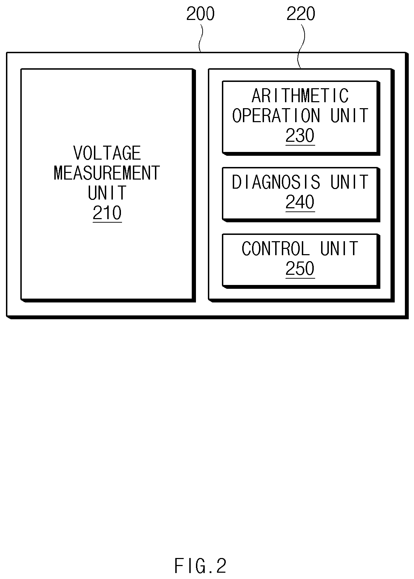

FIG. 2 is a block diagram illustrating the configuration of the BMS 200 according to an embodiment of the present disclosure. The configuration of the BMS 200 may vary according to the usage environment and the application of the battery pack 1000 including the battery module 100, and may include various different operation components.

Referring to FIG. 2, the BMS 200 may include a voltage measurement unit 210 and a controller 220. In an embodiment, the controller 220 may include an arithmetic operation unit 230, a diagnosis unit 240, and a control unit 250. In another embodiment, the BMS 200 may further include, for example, a current measurement unit and/or a temperature measurement unit, in addition to the voltage measurement unit 210.

The voltage measurement unit 210 is configured with a device such as a voltmeter capable of measuring a voltage of a battery bank and/or cell, and may measure the voltage of each of the battery cells 110 to 140 at predetermined time intervals or at unit time intervals to acquire time-series voltage data of each of the battery cells 110 to 140. According to an embodiment, the voltage measurement unit 210 may continuously measure and acquire data of voltage rise/fall and long-term relaxation during charge, relaxation time after charge, discharge, and relaxation time after discharge for each of the battery cells 110 to 140. As needed, the acquired continuous voltage data may be used to diagnose an abnormal battery cell in a particular period among the periods of charge, relaxation time after charge, discharge, and relaxation time after discharge.

In an embodiment, the arithmetic operation unit 230 performs various arithmetic operations for the diagnosis of an abnormal battery cell to be described herein below among the battery cells 110 to 140, by using the voltage data acquired in the voltage measurement unit 210. The diagnosis unit 240 confirms, for example, diagnosis conditions to be described later by using results of the arithmetic operations and diagnoses an abnormal battery cell. Based on the result of the diagnosis, the control unit 250 may take appropriate measures for the abnormal battery cell, such as monitoring the abnormal battery cell or reporting the abnormality to a user.

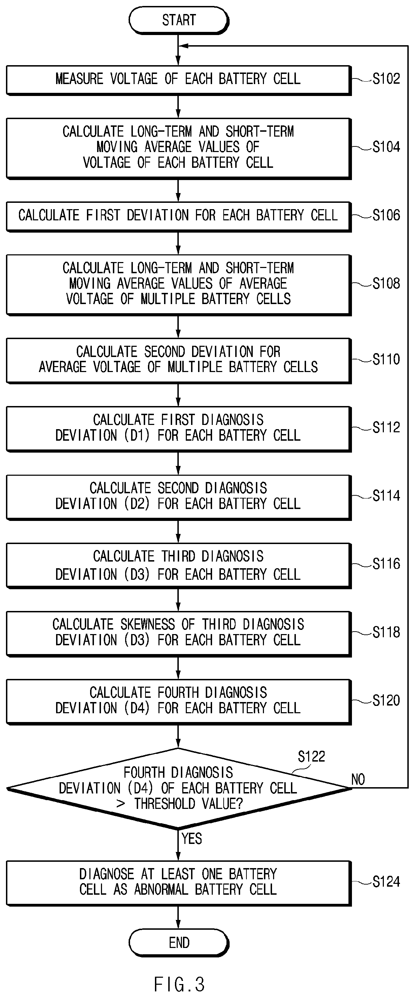

FIG. 3 is a flowchart illustrating the operation method of the BMS 200 according to an embodiment of the present disclosure. Hereinafter, the operation method of the BMS 200 will be described in a step-based manner referring to FIG. 3.

In S102, the voltage measurement unit 210 may measure the voltage of each of the battery cells 110 to 140 at predetermined time intervals, and the controller 220 may generate a graph representing the voltage variation of each of the battery cells 110 to 140. The voltage measurement unit 210 may measure the voltage of each of the battery cells 110 to 140 throughout the periods of charge, relaxation time after charge, discharge, and relaxation time after discharge to continuously acquire data of voltage rise/fall and long-term relaxation, and the controller 220 may generate a graph representing the voltage variation of each of the battery cells 110 to 140 using the measured voltage data. As needed, the voltage measurement unit 210 may continuously measure and acquire data of voltage rise/fall and long-term relaxation in a particular period among the periods of charge, relaxation time after charge, discharge, and relaxation time after discharge for each of the battery cells 110 to 140, and the controller 220 may generate a graph representing the voltage variation of each of the battery cells 110 to 140 using the acquired voltage data.

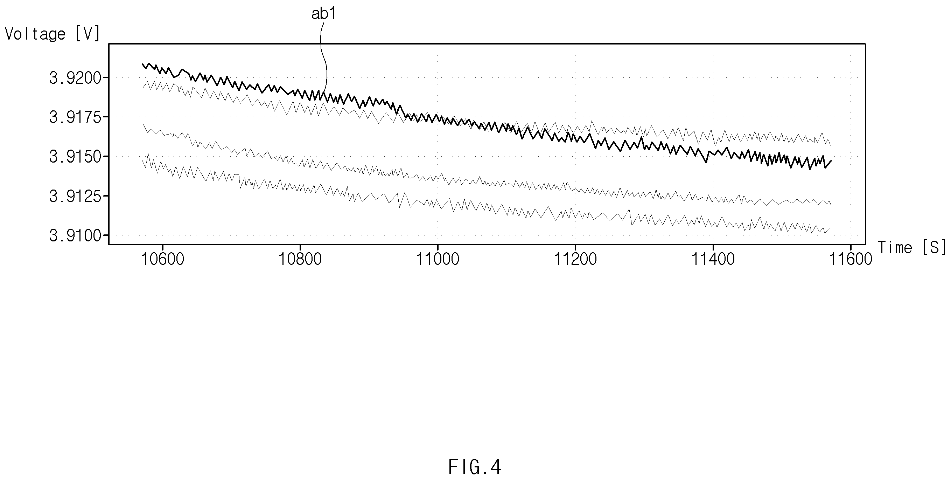

FIG. 4 is a graph representing the voltage variation of each battery cell according to an embodiment of the present disclosure. As an embodiment, the example of FIG. 4 represents the variation of the voltage of each of the battery cells 110 to 140 that is measured at the intervals of 200 seconds during a particular period, for example, from a time after a lapse of 10,600 seconds from the beginning of charge to 11,600 seconds (e.g., the relaxation time after charge), among the voltages measured by the voltage measurement unit 210. In FIG. 4, the graph "ab1" represents the voltage variation of the battery cell 110 among the battery cells 110 to 140 during the relaxation time after charge. In this graph, for example, a reverse peak is observed at the circled portion, in which the voltage drops relatively largely. This implies that the battery cell 110 is exhibiting an abnormal voltage behavior in the corresponding period.

In S104, the controller 220 may calculate a moving average of the measured voltage of each of the battery cells 110 to 140. The moving average refers to an average of a portion of data extracted by moving a window having a predetermined size among overall data. The window is a reference period for determining data to be extracted and used among overall data. The window, for example, begins at a time that precedes by the reference period from the current time and ends at the current time. For example, when the window is one week, the controller 220 may extract voltage data acquired for the latest one-week period ending at the current time from overall voltage data.

The controller 220 may calculate a moving average value of the voltage of each of the battery cells 110 to 140, using voltage data extracted by moving the window among the overall voltage data of each of the battery cells 110 to 140. The controller 220 may continuously calculate the moving average value of the voltage of each of the battery cells 110 to 140, using voltage data continuously extracted by moving the window among the overall voltage data of each of battery cells 110 to 140. The controller 220 may apply any one of a simple moving average (SMA), a weighted moving average (WMA), and an exponential moving average (EMA) to the overall voltage data of each of the battery cells 110 to 140, to calculate the moving average value of the voltage of each of the battery cells 110 to 140.

According to an embodiment, the controller 220 may apply the exponential moving average (EMA) to the overall voltage data of each of the battery cells 110 to 140, to calculate an exponential moving average value of the voltage of each of the battery cells 110 to 140. The exponential moving average is a type of weighted moving average, which uses data over all past time periods while placing a greater weight on the recent data.

The controller 220 may calculate a plurality of moving average values by applying windows with different sizes to the voltage data of each of the battery cells 110 to 140. In an embodiment, the controller 220 may continuously calculate a long-term moving average value and a short-term moving average value at unit time intervals (e.g., 200 seconds), by applying a relatively long window and a relatively short window, respectively, to the overall voltage data of each of the battery cells 110 to 140. For example, the size of the window for the long-term moving average value may include 100 seconds, and the size of the window for the short-term moving average value may include 10 seconds. For example, among the voltage data of each of the battery cells 110 to 140, the controller 220 may calculate the long-term moving average value of the voltage of each of the battery cells 110 to 140 by using the voltage data acquired every second for the latest 100 seconds preceding the calculation time, and the short-term moving average value of the voltage of each of the battery cells 110 to 140 by using the voltage data acquired every second for the latest 10 seconds preceding the calculation time.

With the continuous long-term moving average value V_LMA and short-term moving average value V_SMA for each of the battery cells 110 to 140, the controller 220 may analyze the long-term voltage variation trend and the short-term voltage variation trend for each of the battery cells 110 to 140. Further, the controller 220 may diagnose whether an abnormality is present in each of the battery cells 110 to 140, using the long-term moving average value V_LMA and the short-term moving average value V_SMA of the voltage of each of the battery cells 110 to 140.

In S106, the controller 220 may calculate a plurality of first deviations V_LMA-V_SMA at unit time intervals (e.g., 200 seconds), each of which is a deviation between the long-term moving average value V_LMA and the short-term moving average value V_SMA of the voltage of each of the battery cells 110 to 140. For example, the controller 220 may continuously calculate the plurality of first deviations V_LMA-V_SMA, which are calculated at each unit time interval for the battery cells 110 to 140, respectively, at unit time intervals (e.g., 200 seconds). In S106, the controller 220 may continuously calculate the deviation between the long-term and short-term behaviors of the voltage of each of the battery cells 110 to 140.

In S108, the controller 220 may calculate a long-term moving average value Vavg_LMA and a short-term moving average value Vavg_SMA of an average voltage V_avg of the battery cells 110 to 140 at unit time intervals (e.g., 200 seconds). Here, the average voltage V_avg of the battery cells 110 to 140 at each unit time interval (e.g., 200 seconds) may include a mean value, a median value, or a minimum value of the voltages of the battery cells 110 to 140.

The controller 220 may continuously calculate the average voltage V_avg of the battery cells 110 to 140 at unit time intervals (e.g., 200 seconds), and calculate the long-term moving average value Vavg_LMA and the short-term moving average value Vavg_SMA of the average voltage V_avg of the battery cells 110 to 140 by using the calculated average voltage V_avg of the battery cells 110 to 140. Here, the size of the window for the long-term moving average value Vavg_LMA of the average voltage V_avg of the battery cells 110 to 140 may be the same as the size of the window for the long-term moving average value V_LMA of the voltage of each of the battery cells 110 to 140 (e.g., 100 seconds). Further, the size of the window for the short-term moving average value Vavg_SMA of the average voltage V_avg of the battery cells 110 to 140 may be the same as the size of the window for the short-term moving average value V_SMA of the voltage of each of the battery cells 110 to 140 (e.g., 10 seconds).

In S110, the controller 220 may continuously calculate a second deviation Vavg_LMA-Vavg_SMA, which is a deviation between the long-term moving average value Vavg_LMA and the short-term moving average value Vavg_SMA of the average voltage V_avg of the battery cells 110 to 140, at unit time intervals (e.g., 200 seconds). In S110, the controller 220 may calculate a deviation between the long-term and short-term behaviors of the average voltage V_avg of the battery cells 110 to 140.

In S112, the controller 220 may calculate a first diagnosis deviation D1, which is a deviation between each of the plurality of first deviations V_LMA-V_SMA and the second deviation Vavg_LMA-Vavg_SMA, for each of the battery cells 110 to 140. Specifically, the controller 220 may calculate the first diagnosis deviation D1 of each of the battery cells 110 to 140 based on Equation 1 below.

[Equation 1]

$$\text{First Diagnosis Deviation (D1)} = \text{First Deviation-Second Deviation}$$
$$= (\text{V\_LMA-V\_SMA})-(\text{V}_{avg}\_\text{LMA} - \text{V}_{avg}\_\text{SMA})$$

Referring to Equation 1, the controller 220 may calculate the deviation between each of the plurality of first deviations V_LMA-V_SMA and the second deviation Vavg_LMA-Vavg_SMA, as the first diagnosis deviation D1 of each of the battery cells 110 to 140.

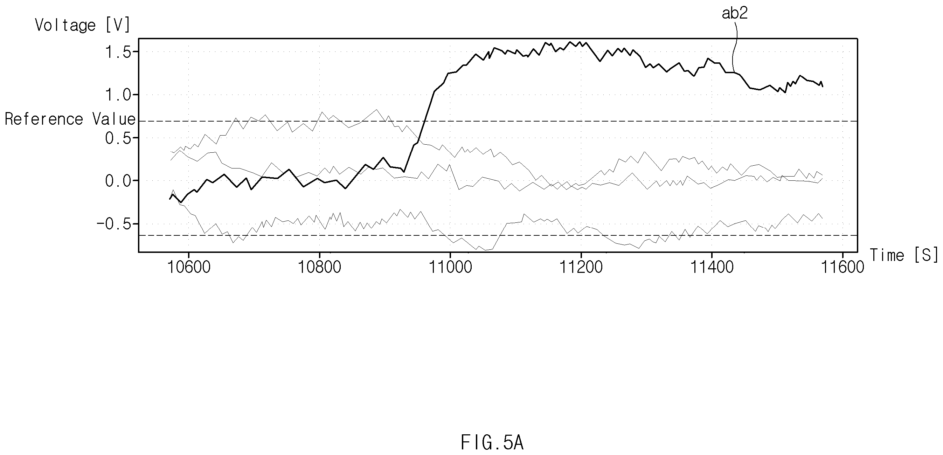

FIG. 5A is a graph illustrating the first diagnosis deviation D1 of each battery cell according to an embodiment of the present disclosure. Referring to FIG. 5A, the controller 220 may continuously calculate the first diagnosis deviation D1 of each of the battery cells 110 to 140 at unit time intervals during the particular period, and generate a graph representing the variation of the first diagnosis deviation D1 of each of the battery cells 110 to 140.

The controller 220 may continuously calculate the first diagnosis deviation D1 of each of the battery cells 110 to 140 at unit time intervals (e.g., 200 seconds), to compare the deviation between the long-term and short-term behaviors of the voltage of each of the battery cells 110 to 140 with the deviation between the long-term and short-term behaviors of the average voltage V_avg of the battery cells 110 to 140. As an embodiment, the graph "ab2" in FIG. 5A may represent the variation of the first diagnosis deviation D1 of the battery cell 110. As in the graph of FIG. 4 for the result of voltage measurement, the first diagnosis deviation D1 of the battery cell 110 in FIG. 5A also exhibits an unusual behavior and exceeds a reference value to be described below in a specific range, as compared to the other battery cells.

In S114, the controller 220 may calculate a second diagnosis deviation D2 for each of the battery cells 110 to 140 by removing the noise data of the first diagnosis deviation D1 of each of the battery cells 110 to 140.

For example, the controller 220 may set the reference value for determining whether the first diagnosis deviation D1 of each of the battery cells 110 to 140 is noise, based on Equation 2 below.

[Equation 2]

$$\text{Reference Value} = \text{Max}[|V_{avg}\_LMA - V_{avg}\_SMA| * C1, C2]$$

The controller 220 may set the reference value for each of the battery cells 110 to 140 to a maximum value Max between a value obtained by multiplying the absolute value of the second deviation (|Vavg_LMA-Vavg_SMA|) by a first threshold constant C1 (|Vavg_LMA-Vavg_SMA|*C1), and a second threshold constant C2. In an embodiment, the first threshold constant C1 may include "0.1," and the second threshold constant C2 may include "0.4." The first and second threshold constants C1 and C2 may vary according to the magnitude and characteristic of the voltage data of each of the battery cells 110 to 140.

As an example of the noise removal, when the first diagnosis deviation D1 of any one of the battery cells 110 to 140 is equal to or less than the reference value, the controller 220 may determine the corresponding first diagnosis deviation D1 to be noise data. The controller 220 may calculate the second diagnosis deviation D2 of each of the battery cells 110 to 140, by excluding the first diagnosis deviation D1 of each of the battery cells 110 to 140, which is equal to or less than the reference value.

In S116, the controller 220 may calculate a third diagnosis deviation D3 for each of the battery cells 110 to 140 by normalizing the second diagnosis deviation D2 of each of the battery cells 110 to 140.

Specifically, the controller 220 may normalize the second diagnosis deviation D2 of each of the battery cells 110 to 140 based on Equation 3 below, to calculate the third diagnosis deviation D3 of each of the battery cells 110 to 140.

[Equation 3]

$$\text{Third Diagnosis Deviation (D3)} = \frac{\text{Second Diagnosis Deviation (D2)}}{\text{Max}[|V_{avg}\_LMA - V_{avg}\_SMA| * C3, C4]}$$

The controller 220 may calculate a maximum value Max between a value obtained by multiplying the absolute value of the second deviation (|Vavg_LMA-Vavg_SMA|) by a third threshold constant C3 (|Vavg_LMA-Vavg_SMA|*C3), and a fourth threshold constant C4. The controller 220 may then normalize the second diagnosis deviation D2 of each of the battery cells 110 to 140 by dividing the second diagnosis deviation D2 with the maximum value Max between the value obtained by multiplying the absolute value of the second deviation representing the behavior of the average voltage V_avg of the battery cells 110 to 140 by the third threshold constant C3, and the fourth threshold constant C4 (Max[|Vavg_LMA-Vavg_SMA|*C3,C4]) to calculate the third diagnosis deviation D3. Here, the third threshold constant C3 may include "0.1," and the fourth threshold constant C4 may include "0.1." The third and fourth threshold constants C3 and C4 may vary according to the magnitude and characteristic of the voltage data of each of the battery cells 110 to 140.

As another example of the normalization, in an embodiment, the controller 220 may normalize the second diagnosis deviation D2 of each of the battery cells 110 to 140 using a logarithmic (log) operation. The controller 220 may calculate a value obtained by normalizing the second diagnosis deviation D2 of each of the battery cells 110 to 140 using the log operation, as the third diagnosis deviation D3 of each of the battery cells 110 to 140.

As yet another example of the normalization, in an embodiment, the controller 220 may set an average value of the second diagnosis deviations D2 (D2_avg) of the battery cells 110 to 140 as a normalization reference value. While using the average value of the second diagnosis deviations D2 (D2_avg) as the normalization reference value, in S116, the controller 220 may normalize the second diagnosis deviation D2 of each of the battery cells 110 to 140 by dividing the second diagnosis deviation D2 by the average value of the second diagnosis deviations D2 (D2_avg). The controller 220 may calculate a value normalized by dividing the second diagnosis deviation D2 of each of the battery cells 110 to 140 by the average value of the second diagnosis deviations D2 (D2_avg), as the third diagnosis deviation D3 of each of the battery cells 110 to 140.

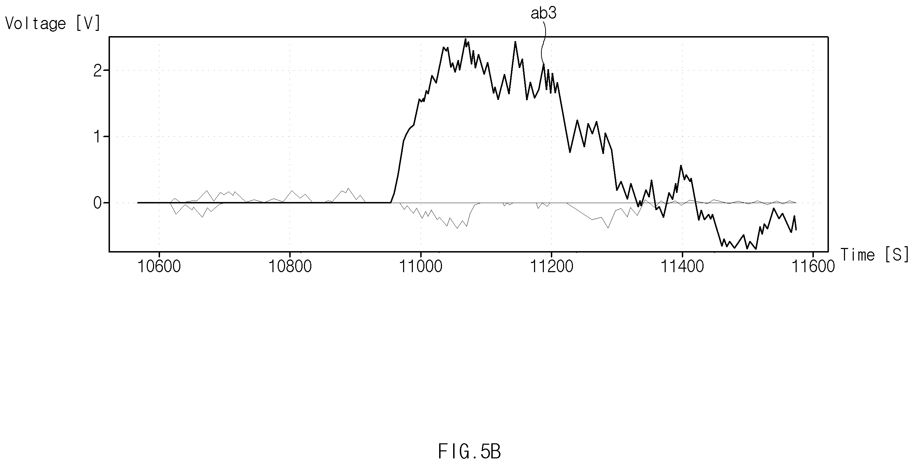

FIG. 5B is a graph illustrating the third diagnosis deviation D3 of each battery cell according to an embodiment of the present disclosure. Referring to FIG. 5B, the controller 220 may normalize the second diagnosis deviation D2 of each of the battery cells 110 to 140 according to the various embodiments, to calculate the third diagnosis deviation D3 of each of the battery cells 110 to 140.

The controller 220 may continuously calculate the third diagnosis deviation D3 of each of the battery cells 110 to 140 at unit time intervals, and generate a graph representing the variation of the third diagnosis deviation D3 of each of the battery cells 110 to 140. As an embodiment, the graph "ab3" in FIG. 5B may represent the variation of the third diagnosis deviation D3 of the battery cell 110. As can be seen in FIG. 5B, the third diagnosis deviation D3 of the battery cell 110 exhibits values equal to or larger than 0 (zero) in a specific range.

In S118, the controller 220 may calculate the skewness of the third diagnosis deviation D3 of each of the battery cells 110 to 140. Specifically, the controller 220 may calculate the skewness of the third diagnosis deviation D3 of each of the battery cells 110 to 140 based on Equation 4 below.

[Equation 4]

$$\text{Skewness} = \frac{(\text{Third Diagnosis Deviation (D3)} + \text{Min[Third Diagnosis Deviation (D3)]})}{\text{Third Diagnosis Deviation (D3)}}$$

Referring to Equation 4, the controller 220 may calculate the skewness of the third diagnosis deviation D3 of each of the battery cells 110 to 140, by adding a minimum value of the third diagnosis deviations D3 of the battery cells 110 to 140 (Min[Third Diagnosis Deviation D3]) to the third diagnosis deviation D3 of each of the battery cells 110 to 140 and dividing the obtained value by the third diagnosis deviation D3.

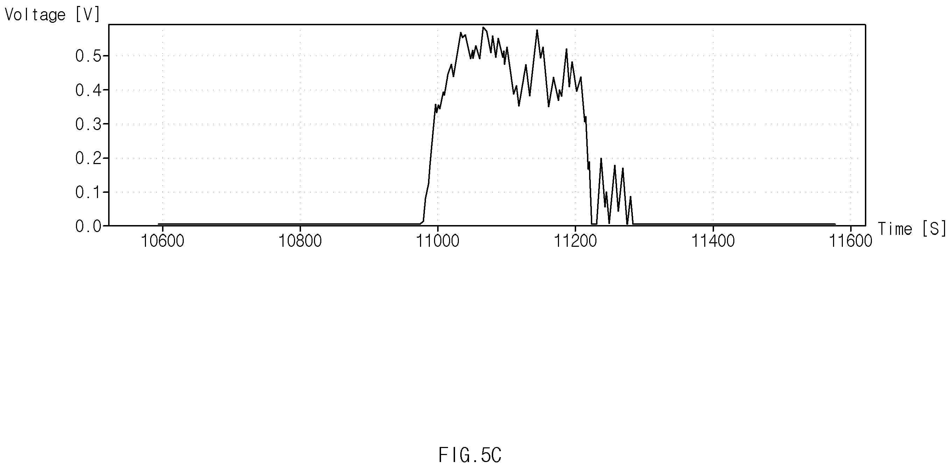

FIG. 5C is a graph illustrating the skewness of the third diagnosis deviation D3 of each battery cell according to an embodiment of the present disclosure.

Referring to FIG. 5C, the controller 220 may continuously calculate the skewness of the third diagnosis deviation D3 of each of the battery cells 110 to 140 at unit time intervals of 200 seconds during the particular period between 10,600 seconds and 11,600 seconds, and generate a graph representing the variation of the skewness of the third diagnosis deviation D3 of each of the battery cells 110 to 140. As an embodiment, the graph of FIG. 5C may represent the variation of the skewness of the third diagnosis deviation D3 of the battery cell 110. As compared to the third diagnosis deviation D3 in FIG. 5B, the skewness of the third diagnosis deviation D3 in FIG. 5C shows an improved clarity which will lead into an improved diagnosis result.

In S120, the controller 220 may calculate a fourth diagnosis deviation D4 for each of the battery cells 110 to 140 by reflecting the skewness on the third diagnosis deviation D3 of each of the battery cells 110 to 140. Specifically, the controller 220 may calculate the fourth diagnosis deviation D4 of each of the battery cells 110 to 140 based on Equation 5 below.

[Equation 5]

$$\text{Fourth Diagnosis Deviation (D4)} = \text{Third Diagnosis Deviation (D3)} * \text{Skewness}$$

The controller 220 may multiply the third diagnosis deviation D3 of each of the battery cells 110 to 140 by the skewness to calculate the fourth diagnosis deviation D4 of each of the battery cells 110 to 140 at unit time intervals (e.g., 200 seconds).

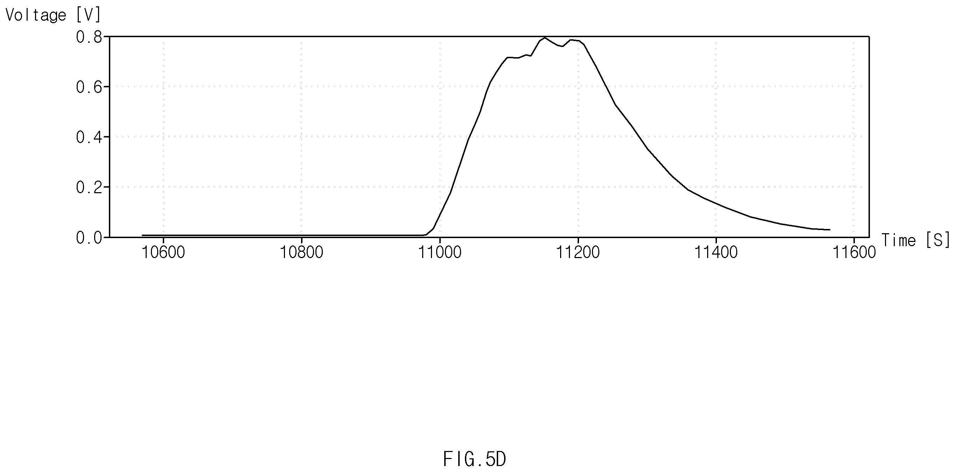

FIG. 5D is a graph illustrating the fourth diagnosis deviation D4 of a battery cell according to an embodiment of the present disclosure. Referring to FIG. 5D, the controller 220 may continuously calculate the fourth diagnosis deviation D4 of each of the battery cells 110 to 140 at unit time intervals (e.g., 200 seconds), and generate a graph representing the variation of the fourth diagnosis deviation D4 of each of the battery cells 110 to 140. As an embodiment, the graph of FIG. 5D may represent the variation of the fourth diagnosis deviation D4 of the battery cell 110. As can be seen in FIG. 5D, the fourth diagnosis deviation D4 to which the skewness is applied exhibits the more stabilized and accurate diagnosis deviation in which noise is reduced and an abnormal voltage behavior signal is amplified, as compared to the third diagnosis deviation D3 to which the skewness is not applied.

In S122, the controller 220 may determine whether the fourth diagnosis deviation D4 of each of the battery cells 110 to 140 exceeds a threshold value. The threshold value may be defined as a reference value for determining an immoderate result to be "abnormal." The threshold value may be defined as a standard that presents how much data deviates from a particular statistical model. When the fourth diagnosis deviation D4 of any of the battery cells 110 to 140 exceeds the threshold value, the controller 220 may determine the corresponding battery cell to be a battery cell with an abnormal voltage behavior. Here, the threshold value is determined in consideration of the state of each battery cell, the sensitivity of a measurement system, and the measurement environment, and may vary according to, for example, the type of battery cell and/or a vehicle to which battery cells are applied. In the example of FIG. 5D, for example, assuming that the threshold value is set to 0.4 V, the controller 220 may determine the battery cell 110 to be a battery cell with an abnormal voltage behavior because the fourth diagnosis deviation D4 of the battery cell 110 exceeds 0.4 V at a specific period.

Meanwhile, when it is determined in S122 that the fourth diagnosis deviation D4 does not exceed the threshold value, the process returns to S102 to repeat the measurement, calculation, and diagnosis process. In another embodiment, the process may not return to S102 but may return to any of the steps prior to S116 to repeat the process.

In S124, based on the result of the determination of whether the fourth diagnosis deviation D4 of each of the battery cells 110 to 140 exceeds the threshold value, the controller 220 may diagnose at least one battery cell among the battery cells 110 to 140 to be an abnormal battery cell. When the fourth diagnosis deviation D4 of at least one battery cell among the battery cells 110 to 140 exceeds the threshold value, the controller 220 may diagnose the at least one battery cell to be a battery cell with an abnormal voltage behavior.

In S124, according to an embodiment, when the fourth diagnosis deviation D4 of at least one battery cell among the battery cells 110 to 140 exceeds the threshold value, the controller 220 may increase a diagnosis count value for the at least one battery cell. In an embodiment, when the fourth diagnosis deviation D4 of at least one battery cell among the battery cells 110 to 140 exceeds the threshold value for the first time, the controller 220 may not instantly diagnose the at least one battery cell to be an abnormal battery cell. Instead, the controller 220 may diagnose the at least one battery cell to be an abnormal battery cell when the diagnosis count value of the at least one battery cell is equal to or more than a threshold count value, for example, when a preset time (e.g., threshold count) elapses after the fourth diagnosis deviation D4 of the at least one battery cell exceeds the threshold value. Thus, the diagnosis of an abnormal battery cell may not be performed for a battery cell, of which fourth diagnosis deviation D4 momentarily exceeds the threshold value, and thereafter, drops rapidly to the threshold value or lower. Therefore, the reliability of the diagnosis of an abnormal battery cell may be improved.

After diagnosing an abnormality in at least one battery cell among the battery cells 110 to 140, the controller 220 may track and monitor whether defects are occurring in the at least one battery cell, such as the internal short, the external short, and the lithium deposits.

When it is determined that the defects are occurring in the at least one battery cell, the controller 220 may provide information on the corresponding battery cell to the user of the battery cell. For example, the controller 220 may provide information on a battery cell with the internal short to a user terminal through a communication unit (not illustrated) or a display (not illustrated) mounted in, for example, a vehicle or a charger.

As described above, according to an embodiment of the present disclosure, the BMS 200 may accurately diagnose an abnormal battery cell by removing noise of the deviation between the long-term and short-term moving average values of the voltage of each battery cell. The BMS 200 may minimize the distortion of the voltage of each battery cell and remove noise data by using the deviation between the long-term and short-term moving average values of the voltage of each battery cell, and amplify the voltage behavior of a potential abnormal battery cell by reflecting the skewness of the voltage of each battery cell, which may improve the accuracy of the diagnosis.

Further, the BMS 200 may diagnose a battery cell with an abnormal voltage behavior at an earlier stage by using the deviation between the long-term and short-term moving average values of the voltage of each battery cell, which ensures the safety and the reliability of battery energy. Furthermore, the BMS 200 may diagnose a battery cell with an abnormal voltage behavior even in a state where the battery is installed in a vehicle, so that the abnormal battery cell may be easily and quickly diagnosed without needing to be separated from the vehicle.

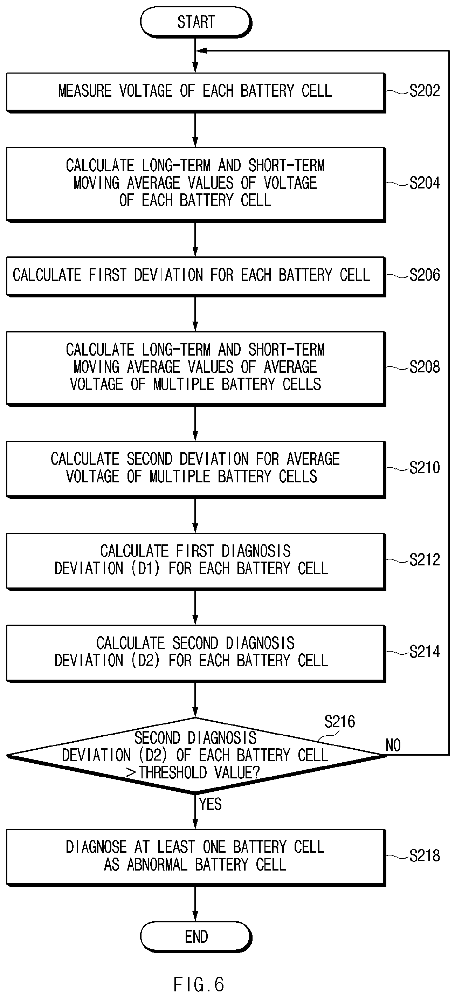

FIG. 6 is a flowchart illustrating an operation method of a battery management system according to another embodiment of the present disclosure.

In the operation method that has been described referring to FIG. 3, the diagnosis of an abnormal battery cell is performed by comparing the fourth diagnosis deviation D4 and the threshold value in S122. However, the present disclosure is not limited thereto. For example, the diagnosis of an abnormal battery cell may be performed at any of the steps prior to S122. For example, the diagnosis of an abnormal battery cell may be performed after calculating the second diagnosis deviation D2 in S114. Hereinafter, this embodiment will be described in a step-based manner with reference to FIG. 6. In order to avoid overlap of descriptions, substantially identical descriptions to those described above will be omitted.

Referring to FIG. 6, in S202, the voltage measurement unit 210 may measure the voltage of each of the plurality of battery cells 110 to 140 at predetermined time intervals, and the controller 220 may generate a graph representing the voltage variation of each of the battery cells 110 to 140. The voltage measurement unit 210 may measure the voltage of each of the battery cells 110 to 140 throughout the periods of charge, relaxation time after charge, discharge, and relaxation time after discharge to continuously acquire data of voltage rise/fall and long-term relaxation, and the controller 220 may generate a graph representing the voltage variation of each of the battery cells 110 to 140 using the measured voltage data.

In S204, the controller 220 may calculate a moving average of the measured voltage of each of the battery cells 110 to 140. According to an embodiment, the controller 220 may calculate an exponential moving average value of the voltage of each of the battery cells 110 to 140 by applying the exponential moving average (EMA) to the overall data of the voltage of each of the battery cells 110 to 140.

The controller 220 may continuously calculate a long-term moving average value and a short-term moving average value at unit time intervals (e.g., 200 seconds), by applying a relatively long window and a relatively short window, respectively, to the overall data of the voltage of each of the battery cells 110 to 140.

In S206, the controller 220 may calculate a plurality of first deviations V_LMA-V_SMA at unit time intervals (e.g., 200 seconds), each of which is a deviation between the long-term moving average value V_LMA and the short-term moving average value V_SMA of the voltage of each of the battery cells 110 to 140.

In S208, the controller 220 may calculate a long-term moving average value Vavg_LMA and a short-term moving average value Vavg_SMA of an average voltage V_avg of the battery cells 110 to 140 at unit time intervals (e.g., 200 seconds). Here, the average voltage V_avg of the battery cells 110 to 140 at each unit time interval (e.g., 200 seconds) may include a mean value, a median value, or a minimum value of the voltages of the battery cells 110 to 140.

In S210, the controller 220 may continuously calculate a second deviation Vavg_LMA-Vavg_SMA, which is a deviation between the long-term moving average value Vavg_LMA and the short-term moving average value Vavg_SMA of the average voltage V_avg of the battery cells 110 to 140, at unit time intervals (e.g., 200 seconds).

In S212, the controller 220 may calculate a first diagnosis deviation D1, which is a deviation between each of the plurality of first deviations V_LMA-V_SMA and the second deviation Vavg_LMA-Vavg_SMA, for each of the battery cells 110 to 140. Specifically, the controller 220 may calculate the first diagnosis deviation D1 of each of the battery cells 110 to 140 based on Equation 1 described above.

In S214, the controller 220 may calculate a second diagnosis deviation D2 for each of the battery cells 110 to 140 by removing the noise data of the first diagnosis deviation D1 of each of the battery cells 110 to 140. Specifically, the controller 220 may set the reference value for determining whether the first diagnosis deviation D1 of each of the battery cells 110 to 140 is noise, based on Equation 2 described above. The controller 220 may calculate the second diagnosis deviation D2 of each of the battery cells 110 to 140, by excluding the first diagnosis deviation D1 of each of the battery cells 110 to 140, which is equal to or less than the reference value.

In S216, the controller 220 may determine whether the second diagnosis deviation D2 of each of the battery cells 110 to 140 exceeds a threshold value. When it is determined in S216 that the second diagnosis deviation D2 does not exceed the threshold value, the process returns to S202 to repeat the measurement, calculation, and diagnosis process. In another embodiment, the process may not return to S202 but may return to any of the steps prior to S214 to repeat the process.

In S218, when the second diagnosis deviation D2 of any of the battery cells 110 to 140 exceeds the threshold value, the controller 220 may diagnose the corresponding battery cell to be an abnormal battery cell.

Hereinafter, yet another embodiment of the present disclosure will be described. According to yet another embodiment of the present disclosure, the BMS 200 may diagnose an abnormal battery cell among the battery cells 110 to 140 by using a deviation dV between an average voltage V_avg of the battery cells 110 to 140 and a voltage of each of the battery cells 110 to 140.

First, the voltage measurement unit 210 may measure the voltage of each of the battery cells 110 to 140 in a similar manner to that in the embodiment described above. The voltage measurement unit 210 may measure the voltage of each of the battery cells 110 to 140 at unit time intervals to acquire time-series data of a first voltage dV of each of the battery cells 110 to 140. In an embodiment, the voltage measurement unit 210 may continuously calculate data of voltage rise/fall and long-term relaxation during charge, relaxation time after charge, discharge, and relaxation time after discharge for each of the battery cells 110 to 140, and the controller 220 may generate a graph representing the voltage variation of each of the battery cells 110 to 140.

Meanwhile, the controller 220 may calculate an average voltage V_avg of the battery cells 110 to 140 at unit time intervals (e.g., 200 seconds) using the voltage data measured as described above. In an embodiment, the controller 220 may calculate a mean value, a median value, or a minimum value of the voltages of the battery cells 110 to 140, as the average voltage V_avg of the battery cells 110 to 140 at each unit time interval (e.g., 200 seconds). Then, the controller 220 may calculate the deviation dV between the average voltage V_avg of the battery cells 110 to 140 and the voltage of each of the battery cells 110 to 140 at unit time intervals (e.g., 200 seconds) for each of the battery cells 110 to 140. According to an embodiment, the controller 220 may calculate the deviation dV between the average voltage V_avg of the battery cells 110 to 140 and the voltage of each of the battery cells 110 to 140, as the first voltage dV.

Hereinafter, descriptions will be made assuming that the first voltage dV of each of the battery cells 110 to 140 is the deviation dV between the average voltage V_avg of the battery cells 110 to 140 and the voltage of each of the battery cells 110 to 140. However, the present disclosure is not limited thereto. For example, according to an embodiment, the controller 220 may calculate the voltage of each of the battery cells 110 to 140 as the first voltage dV of each of the battery cells 110 to 140.

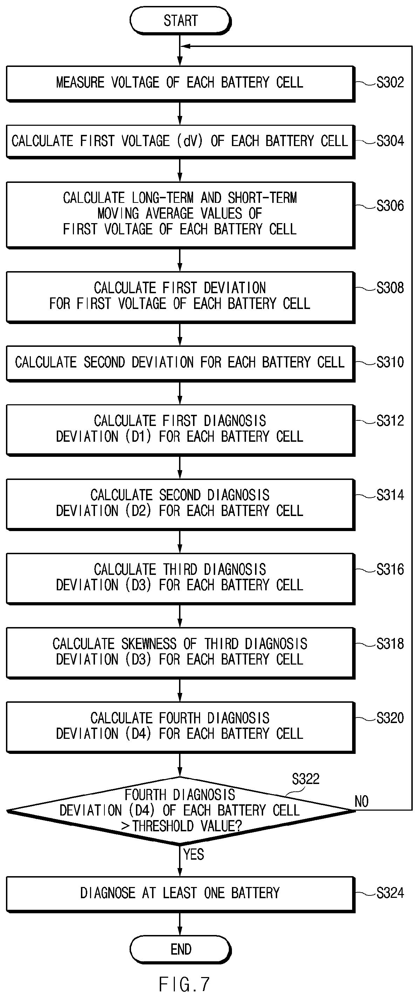

FIG. 7 is a flowchart illustrating the operation method of the BMS 200 and the method of diagnosing an abnormal battery cell according to yet another embodiment of the present disclosure. Hereinafter, the operation method of the BMS 200 will be described in a step-based manner referring to FIG. 7.

In S302, the voltage measurement unit 210 may measure the voltage of each of the battery cells 110 to 140 at predetermined time intervals, and the controller 220 may generate a graph representing the voltage variation of each of the battery cells 110 to 140. The voltage measurement unit 210 may measure the voltage of each of the battery cells 110 to 140 throughout the periods of charge, relaxation time after charge, discharge, and relaxation time after discharge to continuously acquire the data of voltage rise/fall and long-term relaxation, and the controller 220 may generate a graph representing the voltage variation of each of the battery cells 110 to 140 using the measured voltage data. As needed, the voltage measurement unit 210 may continuously measure and acquire data of voltage rise/fall and long-term relaxation in a particular period among the periods of charge, relaxation time after charge, discharge, and relaxation time after discharge for each of the battery cells 110 to 140, and the controller 220 may generate a graph representing the voltage variation of each of the battery cells 110 to 140 using the acquired voltage data.

In S304, by using the voltage data of each of the battery cells 110 to 140 measured in the previous step, the controller 220 may calculate the deviation dV between the average voltage V_avg of the battery cells 110 to 140 and the voltage of each of the battery cells 110 to 140 as the first voltage dV at predetermined time intervals. For example, as a method of calculating the deviation dV between the average voltage V_avg of the battery cells 110 to 140 and the voltage of each of the battery cells 110 to 140 as the first voltage dV, the controller 220 may first add up all of the voltage values of the battery cells 110 to 140 at a particular time t1 and divide the obtained value by four to calculate the resulting average (mean) value as the average voltage V_avg of the battery cells 110 to 140 at the time t1. In another embodiment, instead of calculating the average (mean) value, a median value or a minimum value of the voltage values of the battery cells 110 to 140 at the particular time t1 may be calculated as the average voltage V_avg of the battery cells 110 to 140.

Then, the controller 220 may calculate the deviation dV between the average voltage V_avg of the battery cells 110 to 140 and the voltage of each of the battery cells 110 to 140, as the first voltage dV at predetermined time intervals for each of the battery cells 110 to 140. For example, a difference value between the average voltage V_avg of the battery cells 110 to 140 and the voltage of each of the battery cells 110 to 140 at the particular time t1 is calculated as the first voltage dV of each of the battery cells 110 to 140 at the time t1. This calculation process may be repeated at predetermined time intervals for each of the battery cells 110 to 140, to continuously calculate the first voltage dV.

For example, assuming that the voltages of the battery cells 110 to 140 are 3.92 V, 3.9175 V, 3.9150 V, and 3.9125 V, respectively, at the time of 10,800th second in FIG. 4, the average voltage of the battery cells 110 to 140 at the time of the 10,800th second is 3.91625 V. In this case, the deviation dV between the average voltage V_avg of the battery cells 110 to 140 and the voltage of each of the battery cells 110 to 140 is 0.00375 V (the battery cell 110), 0.00125 V (the battery cell 120), 0.00125 V (the battery cell 130), and 0.00375 V (the battery cell 140). These values are each the first voltage dV at the time of the 10,800th second. The controller 220 repeats this arithmetic operation at unit time intervals to continuously calculate the first voltage dV in the particular period of, for example, the 10,600th second to the 11,600th second.

Meanwhile, in an embodiment, the controller 220 may calculate the voltage of each of the battery cells 110 to 140 measured in the previous step as the first voltage dV, instead of the deviation dV between the average voltage V_avg of the battery cells 110 to 140 and the voltage of each of the battery cells 110 to 140.

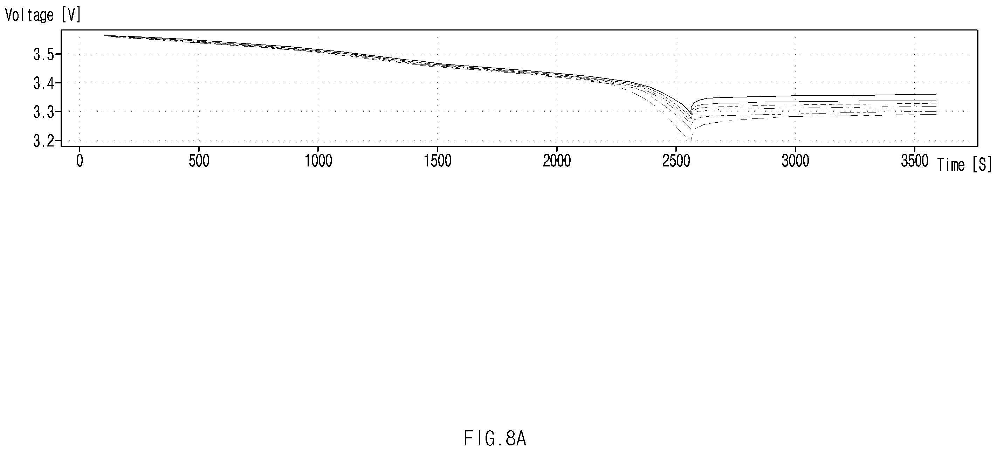

FIG. 8A is a graph illustrating the first voltage dV of each battery cell according to an embodiment of the present disclosure. Referring to FIG. 8A, the controller 220 may measure the voltage of each of the battery cells 110 to 140 during discharge and relaxation time after discharge, for example, the period of 0 seconds to 3,500 seconds, to acquire time-series data of the first voltage dV of each of the battery cells 110 to 140.

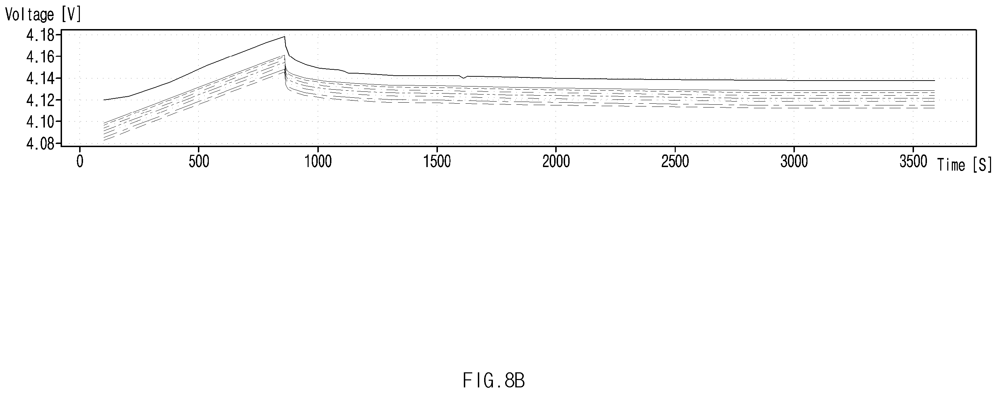

FIG. 8B is a graph illustrating the first voltage dV of each battery cell according to another embodiment of the present disclosure. Referring to FIG. 8B, the controller 220 may measure the voltage of each of the battery cells 110 to 140 during charge and relaxation time after charge, for example, the period of 0 seconds to 3,500 seconds, to acquire time-series data of the first voltage dV of each of the battery cells 110 to 140.

In S306, the controller 220 may calculate a long-term moving average and a short-term moving average of the first voltage dV of each of the battery cells 110 to 140. The moving average refers to an average of some data extracted by moving a window having a predetermined size among overall data. The window is a reference period for determining data to be extracted and used among overall data. The window begins at a time that precedes by the reference period from the current time and ends at the current time. For example, when the window is one week, the controller 220 may extract voltage data acquired for the latest one-week period ending at the current time from overall voltage data.

The controller 220 may continuously calculate a moving average value of the first voltage dV of each of the battery cells 110 to 140, using data of the first voltage dV continuously extracted by moving the window among the overall data of the first voltage dV of each of the battery cells 110 to 140. For example, the controller 220 may calculate the moving average value of the deviation dV between the average voltage V_avg of the battery cells 110 to 140 and the voltage of each of the battery cells 110 to 140, or the voltage of each of the battery cells 110 to 140, by applying any one of a simple moving average (SMA), a weighted moving average (WMA), and an exponential moving average (EMA) to the overall data of the first voltage dV of each of the battery cells 110 to 140.

According to an embodiment, the controller 220 may apply the exponential moving average (EMA) to the overall data of the first voltage dV of each of the battery cells 110 to 140, to calculate an exponential moving average value of the first voltage dV of each of the battery cells 110 to 140. The exponential moving average is a type of weighted moving average, which uses data over all past time periods while placing a greater weight on the recent data.

Specifically, the controller 220 may calculate a plurality of moving average values by applying windows with different sizes to the data of the first voltage dV of each of the battery cells 110 to 140. In an embodiment, the controller 220 may calculate a long-term moving average value and a short-term moving average value by applying a relatively long window and a relatively short window, respectively, to the overall data of the first voltage dV of each of the battery cells 110 to 140. For example, the size of the window for the long-term moving average value may include 100 seconds, and the size of the window for the short-term moving average value may include 10 seconds. For example, with the data of the first voltage dV of each of the battery cells 110 to 140, the controller 220 may calculate the long-term moving average value of the first voltage dV of each of the battery cells 110 to 140 by using the data of the first voltage dV acquired for the latest 100 seconds preceding the calculation time, and the short-term moving average value of the first voltage dV of each of the battery cells 110 to 140 by using the data of the first voltage dV acquired for the latest 10 seconds preceding the calculation time.

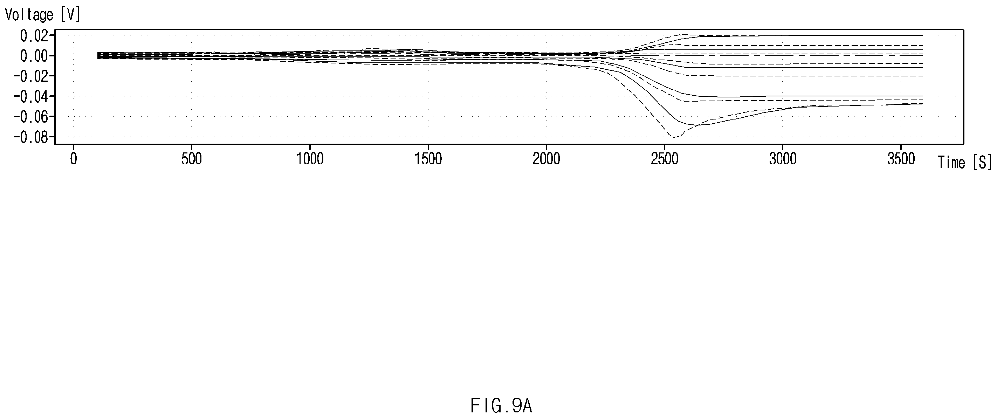

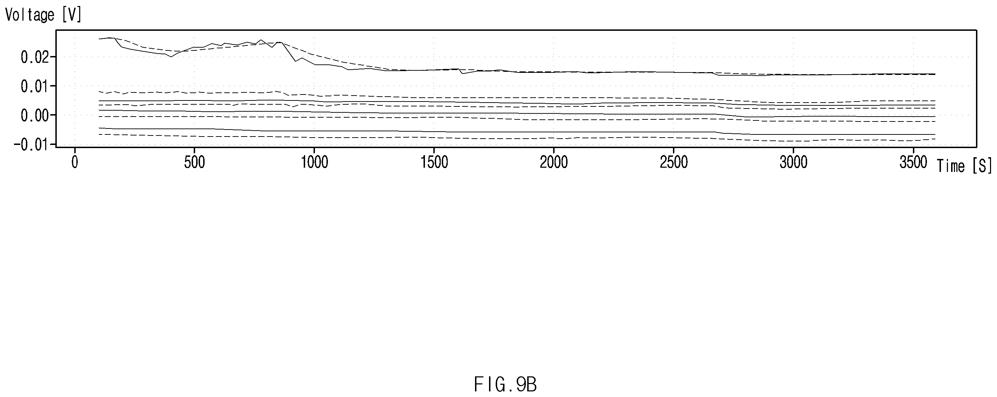

FIG. 9A is a graph illustrating the long-term moving average and the short-term moving average of the first voltage dV of each battery cell during discharge and relaxation time after discharge according to an embodiment of the present disclosure. FIG. 9B is a graph illustrating the long-term moving average and the short-term moving average of the first voltage dV of each battery cell during charge and relaxation time after charge according to another embodiment of the present disclosure.

In an embodiment, in FIGS. 9A and 9B, a dashed graph represents the variation of a short-term moving average dV_SMA of each battery cell, and a solid graph represents the variation of a long-term moving average dV_LMA of each battery cell.

Referring to FIG. 9A, the controller 220 may measure the voltage of each of the battery cells 110 to 140 during discharge and relaxation time after discharge to acquire time-series data of the long-term moving average dV_LMA and the short-term moving average dV_SMA of the first voltage dV of each of the battery cells 110 to 140.

Referring to FIG. 9B, the controller 220 may measure the voltage of each of the battery cells 110 to 140 during charge and relaxation time after charge to acquire time-series data of the long-term moving average dV_LMA and the short-term moving average dV_SMA of the first voltage dV of each of the battery cells 110 to 140.

With the continuous long-term moving average dV_LMA and short-term moving average dV_SMA of the first voltage dV of each of the battery cells 110 to 140, the controller 220 may analyze the long-term voltage variation trend and the short-term voltage variation trend of the first voltage dV of each of the battery cells 110 to 140. The controller 220 may diagnose an abnormality in each of the battery cells 110 to 140 using the long-term moving average dV_LMA and the short-term moving average dV_SMA of the deviation dV between the voltage of each of the battery cells 110 to 140 and the average voltage V_avg of the battery cells 110 to 140, or the voltage of each of the battery cells 110 to 140.

In S308, by using the calculated long-term moving average value dV_LMA and short-term moving average value dV_SMA, the controller 220 may calculate a first deviation dV_LMA-dV_SMA, which is a deviation between the long-term moving average value dV_LMA and the short-term moving average value dV_SMA of the first voltage dV of each of the battery cells 110 to 140, at predetermined time intervals. The controller 220 may continuously calculate the deviation between the long-term and short-term behaviors of the deviation dV between the voltage of each of the battery cells 110 to 140 and the average voltage V_avg of the battery cells 110 to 140, or the voltage of each of the battery cells 110 to 140.

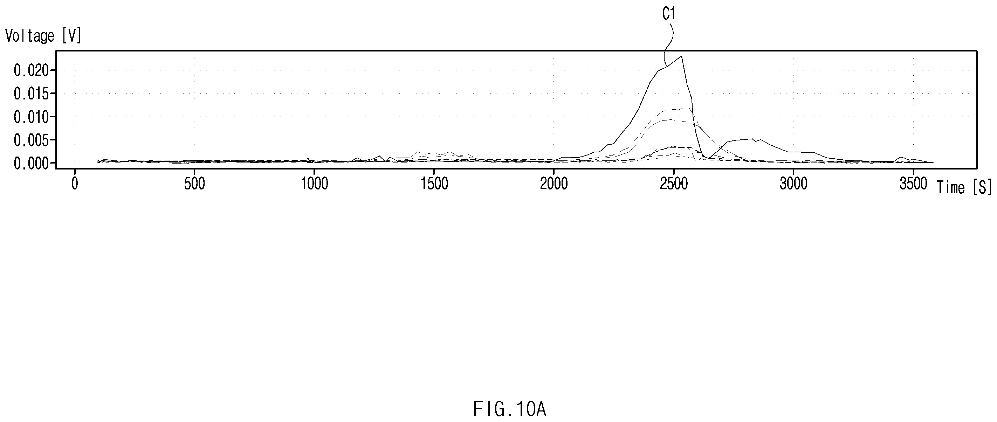

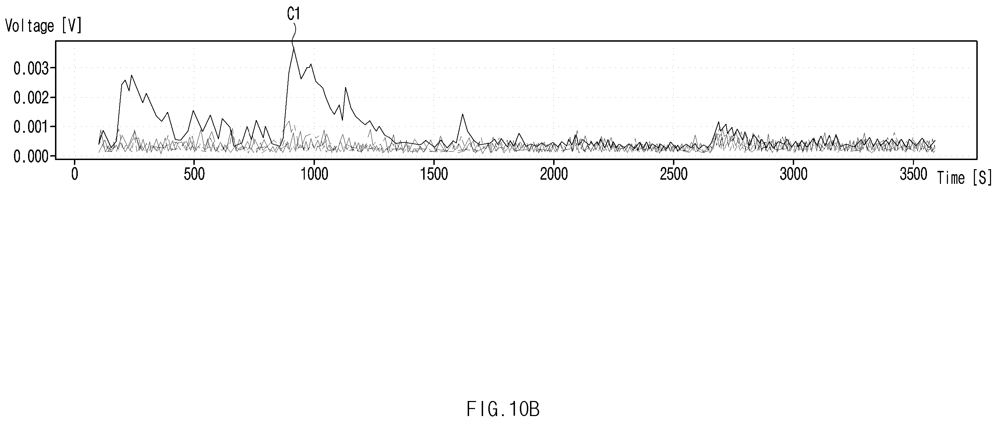

In an embodiment, FIG. 10A is a graph illustrating the first deviation, which is the deviation between the long-term moving average dV_LMA and the short-term moving average dV_SMA of the first voltage dV during discharge and relaxation time after discharge. FIG. 10B is a graph illustrating the first deviation, which is the deviation between the long-term moving average dV_LMA and the short-term moving average dV_SMA of the first voltage dV during charge and relaxation time after charge. In FIGS. 10A and 10B, it is assumed that the graph C1 represents the first deviation of the battery cell 110. The controller 220 may continuously calculate the first deviation dV_LMA-dV_SMA of each of the battery cells 110 to 140 at unit time intervals.

According to embodiments, the deviation between the long-term moving average dV_LMA and the short-term moving average dV_SMA for each of the battery cells 110 to 140 may rely on the short-term variation history and the long-term variation history of the cell voltage.

The temperature or the state of health (SOH) of each of the battery cells 110 to 140 constantly affects the voltage of each of the battery cells 110 to 140 over a long time period as well as a short time period. Accordingly, unless an abnormality occurs in the voltage of each of the battery cells 110 to 140, the deviation between the long-term moving average dV_LMA and the short-term moving average dV_SMA of each of the battery cells 110 to 140 may not significantly differ from the others. Meanwhile, when a voltage abnormality abruptly occurs in a certain battery cell (e.g., the battery cell 110) due to, for example, the internal short and/or the external short, the abnormality may affect the short-term moving average, rather than the long-term moving average. As a result, the corresponding battery cell (e.g., the battery cell 110) may exhibit a relatively significant difference in the deviation between the long-term moving average dV_LMA and the short-term moving average dV_SMA, as compared to the other battery cells without any voltage abnormality.

In S310, the controller 220 may calculate a second deviation (dVLMA-dVSMA)AVG, which is an average value of the first deviations dV_LMA-dV_SMA of the battery cells 110 to 140, at each predetermined unit time interval. While a general mean value may be calculated as the average value of the first deviations dV_LMA-dV_SMA, the controller 220 may calculate a median value or a minimum value of the first deviations dV_LMA-dV_SMA of the battery cells 110 to 140 as the second deviation.

For example, the controller 220 may continuously calculate the first deviation dV_LMA-dV_SMA of each of the battery cells 110 to 140 at unit time intervals. Then, by using the calculated first deviations dV_LMA-dV_SMA of the battery cells 110 to 140, the controller 220 may continuously calculate a mean value, a median value, or a minimum value of the first deviations dV_LMA-dV_SMA of the battery cells 110 to 140, as the second deviation (dVLMA-dVSMA)AVG at each unit time interval. The controller 220 may calculate the average value of the deviations between the long-term and short-term behaviors of the first voltages dV of the battery cells 110 to 140.

In S312, the controller 220 may calculate a first diagnosis deviation D1, which is a difference between the first deviation dV_LMA-dV_SMA of each of the battery cells 110 to 140 and the second deviation (dVLMA-dVSMA)AVG, at each unit time interval for each of the battery cells 110 to 140.

Specifically, the controller 220 may calculate the first diagnosis deviation D1 of each of the battery cells 110 to 140 at each unit time interval based on Equation 6 below.

[Equation 6]

$$\text{First Diagnosis Deviation (D1)} = \text{Second Deviation-First Deviation}$$
$$= ((dV_{LMA}\text{-}dV_{SMA})_{AVG})\text{-}(dV\_LMA\text{-}dV\_SMA)$$

Referring to Equation 6, the controller 220 may calculate the difference between each of the plurality of first deviations dV_LMA-dV_SMA and the second deviation (dVLMA-dVSMA)AVG, as the first diagnosis deviation D1 of each of the battery cells 110 to 140.

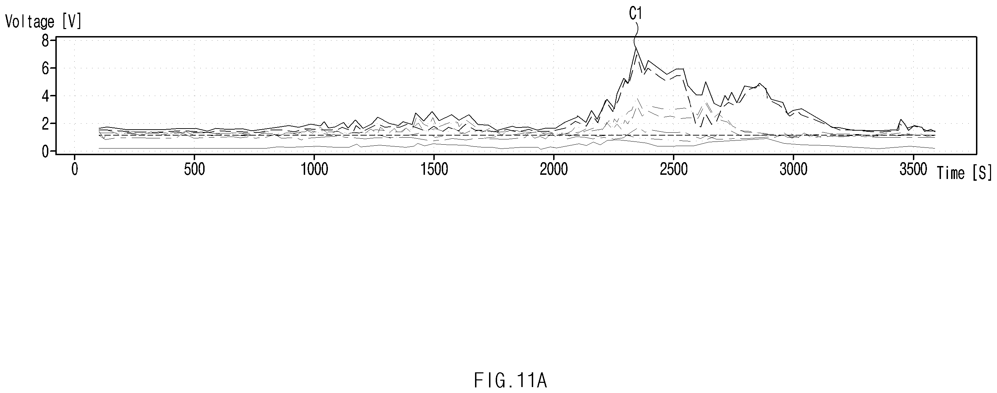

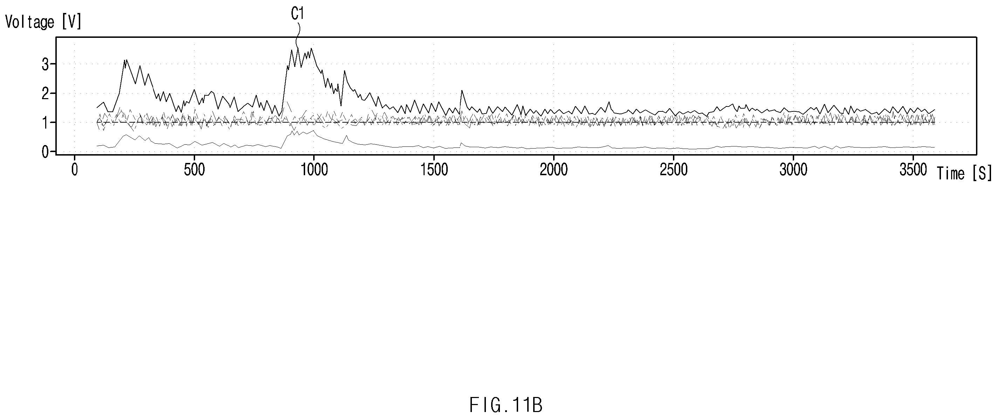

FIG. 11A is a graph illustrating the first diagnosis deviation D1 of each battery cell during discharge and relaxation time after discharge according to an embodiment of the present disclosure. FIG. 11B is a graph illustrating the first diagnosis deviation D1 of each battery cell during charge and relaxation time after charge according to another embodiment of the present disclosure. In order to facilitate the understanding of description, it is assumed that the graph "C1" in FIGS. 11A and 11B represents the first diagnosis deviation D1 of the battery cell 110 among the battery cells 110 to 140.

Referring to FIG. 11A, the voltage measurement unit 210 may measure the voltage of each of the battery cells 110 to 140 at unit time intervals during discharge and relaxation time after discharge, to acquire time-series data of the first diagnosis deviation D1 for each of the battery cells 110 to 140, which is the difference between the first deviation dV_LMA-dV_SMA of each of the battery cells 110 to 140 and the second deviation (dVLMA-dVSMA)AVG.

Referring to FIG. 11B, the voltage measurement unit 210 may measure the voltage of each of the battery cells 110 to 140 at unit time intervals during charge and relaxation time after charge, to acquire time-series data of the first diagnosis deviation D1 for each of the battery cells 110 to 140, which is the difference between the first deviation dV_LMA-dV_SMA of each of the battery cells 110 to 140 and the second deviation (dVLMA-dVSMA)AVG.

The controller 220 may calculate the first diagnosis deviation D1 of each of the battery cells 110 to 140, to compare the deviation between the long-term and short-term behaviors of the first voltage dV of each of the battery cells 110 to 140 with the average of the deviations between the long-term and short-term behaviors of the first voltages dV of the battery cells 110 to 140.

Meanwhile, the controller 220 may calibrate the first voltage dV of each of the battery cells 110 to 140 with the first diagnosis deviation D1 of each of the battery cells 110 to 140. For example, in S312, the controller 220 may input the first diagnosis deviation D1 of each of the battery cells 110 to 140 calculated through S302 to S312, as the first voltage dV of each of the battery cells 110 to 140 in S304, to repeat S304 to S312 and recalculate the first diagnosis deviation D1. According to an embodiment, the controller 220 may input the first diagnosis deviation D1 calculated in S312 as a calibrated first voltage dV' of each of the battery cells 110 to 140, to repeat S304 to S312 once or multiple times and recalculate the first diagnosis deviation D1 of each of the battery cells 110 to 140.

The controller 220 may calculate a moving average value of the calibrated first voltage dV' of each of the battery cells 110 to 140, using the calibrated first voltages dV' extracted by moving the window among time-series data of the first diagnosis deviation D1, e.g., the calibrated first voltage dV' of each of the battery cells 110 to 140.

According to an embodiment, the controller 220 may apply the exponential moving average (EMA) to the calibrated first voltage dV' of each of the battery cells 110 to 140, to calculate an exponential moving average value of the calibrated first voltage dV' of each of the battery cells 110 to 140.

The controller 220 may calculate time-series data of a long-term moving average dV'_LMA and a short-term moving average dV'_SMA of the calibrated first voltage dV' for each of the battery cells 110 to 140. The controller 220 may continuously calculate the long-term moving average dV'_LMA and the short-term moving average dV'_SMA of the calibrated first voltage dV' at unit time intervals for each of the battery cells 110 to 140.

By using the continuous long-term moving average value dV'_LMA and short-term moving average value dV'_SMA of the calibrated first voltage dV' of each of the battery cells 110 to 140, the controller 220 may analyze the long-term voltage variation trend and the short-term voltage variation trend of the calibrated first voltage dV' of each of the battery cells 110 to 140.

According to an embodiment, the controller 220 may input, as the first voltage dV, the first diagnosis deviation D1 calculated from the voltages of the battery cells 110 to 140 during discharge and relaxation time after discharge, to recalculate the first diagnosis deviation D1 of each of the battery cells 110 to 140. According to another embodiment, the controller 220 may input, as the first voltage dV, the first diagnosis deviation D1 calculated from the voltages of the battery cells 110 to 140 during charge and relaxation time after charge, to recalculate the first diagnosis deviation D1 of each of the battery cells 110 to 140.

Then, the controller 220 may calculate a calibrated first deviation dV'_LMA-dV'_SMA for each of the battery cells 110 to 140, which is a deviation between the long-term moving average value dV'_LMA and the short-term moving average value dV'_SMA of the first diagnosis deviation D1, e.g., the calibrated first voltage dV' of each of the battery cells 110 to 140.

The controller 220 may continuously calculate the calibrated first deviation dV'_LMA-dV'_SMA for each of the battery cells 110 to 140 at unit time intervals.

Subsequently, the controller 220 may calculate a calibrated second deviation (dV'LMA-dV'SMA)AVG, which is an average of the calibrated first deviations dV'_LMA-dV'_SMA of the battery cells 110 to 140. Here, the controller 220 may calculate a mean value, a median value, or a minimum value of the calibrated first deviations dV'_LMA-dV'_SMA of the battery cells 110 to 140, as the calibrated second deviation.

Specifically, the controller 220 may continuously calculate the calibrated first deviation dV'_LMA-dV'_SMA of each of the battery cells 110 to 140 at each unit time interval. Then, the controller 220 may calculate a mean value, a median value, or a minimum value of the calibrated first deviations dV'_LMA-dV'_SMA of the battery cells 110 to 140, as the calibrated second deviation (dV'LMA-dV'SMA)AVG, which is the average value of the calibrated first deviations dV'_LMA-dV'_SMA of the battery cells 110 to 140. The controller 220 may continuously calculate the calibrated second deviation (dV'LMA-dV'SMA)AVG of the battery cells 110 to 140 at unit time intervals.

Then, the controller 220 may calculate a calibrated first diagnosis deviation D1, which is a difference between the calibrated first deviation dV'_LMA-dV'_SMA of each of the battery cells 110 to 140 and the calibrated second deviation (dV'LMA-dV'SMA)AVG.

Referring back to FIG. 7, in S314, the controller 220 may remove noise of the first diagnosis deviation D1 of each of the battery cells 110 to 140 based on Equation 7 below, to calculate a second diagnosis deviation D2. To this end, the controller 220 may first set a reference value for determining whether the first diagnosis deviation D1 of each of the battery cells 110 to 140 is noise, based on Equation 7 below.

[Equation 7]

$$\text{Reference Value} = \text{Max}[|dV_{LMA}\text{-}dV_{SMA})_{AVG}| * C1, C2]$$

The controller 220 may set the reference value for each of the battery cells 110 to 140 to a maximum value Max between a value obtained by multiplying the absolute value of the second deviation (|(dVLMA-dVSMA)AVG|) by a first threshold constant C1 (|(dVLMA-dVSMA)AVG|*C1), and a second threshold constant C2. The first threshold constant C1 may include "0.1," and the second threshold constant C2 may include "0.4." The first and second threshold constants C1 and C2 may vary according to the magnitude and characteristic of the first voltage dV of each of the battery cells 110 to 140.

Then, when the first diagnosis deviation D1 of any of the battery cells 110 to 140 is equal to or less than the reference value, the controller 220 may determine the corresponding first diagnosis deviation D1 to be noise data. In S314, the controller 220 may calculate the second diagnosis deviation D2 of each of the battery cells 110 to 140, by excluding the first diagnosis deviation D1 equal to or lower than the reference value among the first diagnosis deviations D1 of the battery cells 110 to 140.

In S316, the controller 220 may normalize the second diagnosis deviation D2 of each of the battery cells 110 to 140 to calculate a third diagnosis deviation D3.

For example, the controller 220 may normalize the second diagnosis deviation D2 of each of the battery cells 110 to 140 based on Equation 8 below, to calculate the third diagnosis deviation D3 of each of the battery cells 110 to 140.

[Equation 8]

$$\text{Third Diagnosis Deviation (D3)} = \frac{\text{Second Diagnosis Deviation (D2)}}{\text{Max}[|dV_{LMA} - dV_{SMA})_{AVG}| * C3, C4]}$$

The controller 220 may calculate a maximum value Max between a value obtained by multiplying the absolute value of the second deviation (|(dVLMA-dVSMA)AVG|) by a third threshold constant C3 (|(dVLMA-dVSMA)AVG|*C3), and a fourth threshold constant C4. The controller 220 may normalize the second diagnosis deviation D2 of each of the battery cells 110 to 140 by dividing the second diagnosis deviation D2 with the maximum value Max between the value obtained by multiplying the absolute value of the second deviation representing the behavior of the average voltage V_avg of the battery cells 110 to 140 by the third threshold constant C3, and the fourth threshold constant C4 (Max[|(dVLMA-dVSMA) AVG|*C3,C4]) to calculate the third diagnosis deviation D3. Here, the third threshold constant C3 may include "0.1," and the fourth threshold constant C4 may include "0.1." The third and fourth threshold constants C3 and C4 may vary according to the magnitude and characteristic of the first voltage dV of each of the battery cells 110 to 140.

In S316, the controller 220 may normalize the second diagnosis deviation D2 of each of the battery cells 110 to 140 according to various embodiments, to calculate the third diagnosis deviation D3 of each of the battery cells 110 to 140.

As another example of the normalization, in an embodiment, the controller 220 may normalize the second diagnosis deviation D2 of each of the battery cells 110 to 140 using a logarithmic (log) operation. The controller 220 may calculate the value obtained by normalizing the second diagnosis deviation D2 of each of the battery cells 110 to 140 using the log operation, as the third diagnosis deviation D3 of each of the battery cells 110 to 140.

As yet another example of the normalization, in an embodiment, the controller 220 may set an average value of the second diagnosis deviations D2 (D2_avg) of the battery cells 110 to 140 as a normalization reference value. While using the average value of the second diagnosis deviations D2 (D2_avg) as the normalization reference value, in S316, the controller 220 may normalize the second diagnosis deviation D2 of each of the battery cells 110 to 140 by dividing the second diagnosis deviation D2 by the average value of the second diagnosis deviations D2 (D2_avg). The controller 220 may calculate a value normalized by dividing the second diagnosis deviation D2 of each of the battery cells 110 to 140 by the average value of the second diagnosis deviations D2 (D2_avg), as the third diagnosis deviation D3 of each of the battery cells 110 to 140.

In S316, the controller 220 may continuously calculate the third diagnosis deviation D3 of each of the battery cells 110 to 140 at unit time intervals, and generate a graph representing the variation of the third diagnosis deviation D3 of each of the battery cells 110 to 140.

In S318, the controller 220 may calculate the skewness of the third diagnosis deviation D3 of each of the battery cells 110 to 140. Specifically, the controller 220 may calculate the skewness of the third diagnosis deviation D3 of each of the battery cells 110 to 140 based on Equation 9 below.

[Equation 9]

$$\text{Skewness} = \frac{(\text{Third Diagnosis Deviation (D3)} + \text{Min}[\text{Third Diagnosis Deviation (D3)}])}{\text{Third Diagnosis Deviation (D3)}}$$

Referring to Equation 9, the controller 220 may calculate the skewness of the third diagnosis deviation D3 of each of the battery cells 110 to 140, by adding a minimum value of the third diagnosis deviations D3 of the battery cells 110 to 140 (Min[Third Diagnosis Deviation D3]) to the third diagnosis deviation D3 of each of the battery cells 110 to 140, and dividing the obtained value by the third diagnosis deviation D3.

The controller 220 may continuously calculate the skewness of the third diagnosis deviation D3 of each of the battery cells 110 to 140 at unit time intervals, and generate a graph representing the variation of the skewness of the third diagnosis deviation D3 of each of the battery cells 110 to 140.

In S320, the controller 220 may calculate a fourth diagnosis deviation D4 for each of the battery cells 110 to 140 by reflecting the skewness on the third diagnosis deviation D3 of each of the battery cells 110 to 140. Specifically, the controller 220 may calculate the fourth diagnosis deviation D4 of each of the battery cells 110 to 140 based on Equation 10 below.

[Equation 10]

$$\text{Fourth Diagnosis Deviation (D4)} = \text{Third Diagnosis Deviation (D3)} * \text{Skewness}$$

The controller 220 may multiply the third diagnosis deviation D3 of each of the battery cells 110 to 140 by the skewness to calculate the fourth diagnosis deviation D4 of each of the battery cells 110 to 140 at unit time intervals (e.g., 200 seconds). As described above, the fourth diagnosis deviation D4 to which the skewness is applied exhibits the more stabilized and accurate diagnosis deviation in which noise is reduced and an abnormal voltage behavior signal is amplified, as compared to the third diagnosis deviation D3 to which the skewness is not applied.

The controller 220 may continuously calculate the fourth diagnosis deviation D4 of each of the battery cells 110 to 140 at unit time intervals, and generate a graph representing the variation of the fourth diagnosis deviation D4 of each of the battery cells 110 to 140.

In S322, the controller 220 may determine whether the fourth diagnosis deviation D4 of each of the battery cells 110 to 140 exceeds a threshold value. The threshold value may be defined as a reference value for determining an immoderate result to be "abnormal." The threshold value may be defined as a standard that presents how much data deviates from a particular statistical model. When the fourth diagnosis deviation D4 of any of the battery cells 110 to 140 exceeds the threshold value, the controller 220 may determine the corresponding battery cell to be a battery cell with an abnormal voltage behavior. Here, the threshold value is determined in consideration of the state of each battery cell, the sensitivity of a measurement system, and the measurement environment, and may vary according to, for example, the type of battery cell and/or a vehicle to which battery cells are applied.

Meanwhile, when it is determined in S322 that the fourth diagnosis deviation D4 does not exceed the threshold value, the process returns to S302 to repeat the measurement, calculation, and diagnosis process. In another embodiment, the process may not return to S302 but may return to any of the steps prior to S322 to repeat the process.

In S322, based on the result of the determination of whether the fourth diagnosis deviation D4 of each of the battery cells 110 to 140 exceeds the threshold value, the controller 220 may diagnose at least one battery cell among the battery cells 110 to 140 to be an abnormal battery cell. When the fourth diagnosis deviation D4 of at least one battery cell among the battery cells 110 to 140 exceeds the threshold value, the controller 220 may diagnose the at least one battery cell to be a battery cell with an abnormal voltage behavior.

In S324, according to an embodiment, when the fourth diagnosis deviation D4 of at least one battery cell among the battery cells 110 to 140 exceeds the threshold value, the controller 220 may increase a diagnosis count value of the at least one battery cell.

According to an embodiment, the controller 220 may diagnose an anomaly of at least one battery cell among the battery cells 110 and 140, when the diagnosis count value of the at least one battery cell is equal to or more than a threshold count value.

In an embodiment, when the fourth diagnosis deviation D4 of at least one battery cell among the battery cells 110 to 140 exceeds the threshold value for the first time, the controller 220 may not instantly diagnose the at least one battery cell to be an abnormal battery cell. Instead, the controller 220 may diagnose the at least one battery cell to be an abnormal battery cell when the diagnosis count value of the at least one battery cell is equal to or more than the threshold count value, for example, when a preset time (e.g., threshold count) elapses after the fourth diagnosis deviation D4 of the at least one battery cell exceeds the threshold value. Thus, the diagnosis of an abnormal battery cell may not be performed for a battery cell, of which fourth diagnosis deviation D4 momentarily exceeds the threshold value, and thereafter, drops rapidly to the threshold value or lower. Therefore, the reliability of the diagnosis of an abnormal battery cell may be improved.

In the diagnosing method that has been described, the diagnosis of an abnormal battery cell is performed by comparing the fourth diagnosis deviation D4 and the threshold value in S322. However, the present disclosure is not limited thereto. For example, the diagnosis of an abnormal battery cell may be performed at any of the steps prior to S322. For example, the diagnosis of an abnormal battery cell may be performed after calculating the second diagnosis deviation D2 in S314.

After diagnosing an abnormality in at least one battery cell among the battery cells 110 to 140, the controller 220 may track and monitor whether defects are occurring in the at least one battery cell, such as the internal short, the external short, and the lithium deposits.

When it is determined that the defects are occurring in the at least one battery cell, the controller 220 may provide information on the corresponding battery cell to a user. For example, the controller 220 may provide information on a battery cell with the internal short to a user terminal through a communication unit (not illustrated) or a display (not illustrated) mounted in, for example, a vehicle or a charger.

As described above, according to another embodiment of the present disclosure, the BMS 200 may accurately diagnose an abnormal battery cell by removing noise of the deviation between the long-term and short-term moving average values of the voltage deviation between the voltage of each of the battery cells and the average voltage of the battery cells.

The BMS 200 according to the present disclosure may minimize the distortion of the voltage of each battery cell and remove noise data by using the deviation between the long-term and short-term moving average values of the voltage deviation of each battery cell, and amplify the voltage behavior of an abnormal battery cell by reflecting the skewness of the voltage of the battery cell, which may improve the accuracy of the diagnosis.

Further, the BMS 200 according to the present disclosure may diagnose a battery cell with an abnormal voltage behavior at an earlier time by using the deviation between the long-term and short-term moving average values of the voltage deviation of each battery cell, which ensures the safety and the reliability of battery energy. Furthermore, the BMS 200 may diagnose a battery cell with an abnormal voltage behavior even in a state where the battery is installed in a vehicle, so that the abnormal battery cell may be easily and quickly diagnosed without needing to be separated from the vehicle.

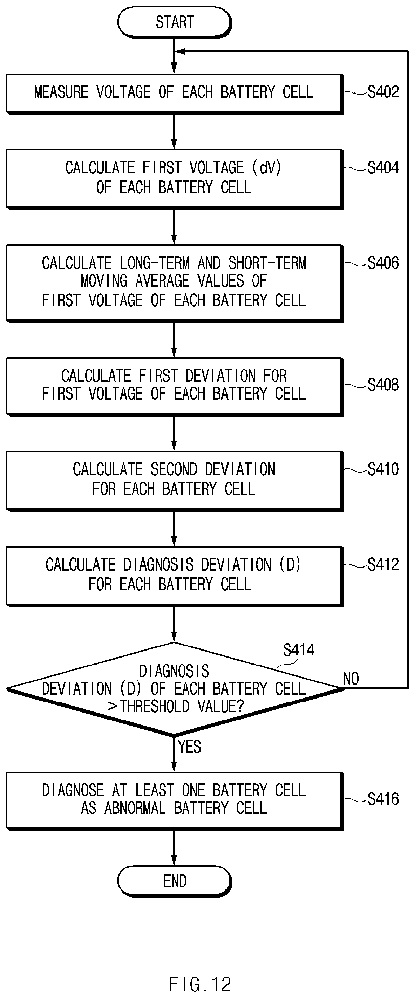

FIG. 12 is a flowchart illustrating the operation method of the BMS 200 according to yet another embodiment of the present disclosure. Hereinafter, the operation method of the BMS 200 will be described in a step-based manner referring to FIG. 12.

In S402, the voltage measurement unit 210 may measure the voltage of each of the battery cells 110 to 140 at predetermined time intervals, and the controller 220 may generate a graph representing the voltage variation of each of the battery cells 110 to 140. The voltage measurement unit 210 may measure the voltage of each of the battery cells 110 to 140 throughout the periods of charge, relaxation time after charge, discharge, and relaxation time after discharge to continuously acquire data of voltage rise/fall and long-term relaxation, and the controller 220 may generate a graph representing the voltage variation of each of the battery cells 110 to 140 using the measured voltage data. As needed, the voltage measurement unit 210 may continuously measure and acquire data of voltage rise/fall and long-term relaxation in a particular period among the periods of charge, relaxation time after charge, discharge, and relaxation time after discharge for each of the battery cells 110 to 140, and the controller 220 may generate a graph representing the voltage variation of each of the battery cells 110 to 140 using the acquired voltage data.

In S404, the controller 220 may calculate a deviation dV between the average voltage V_avg of the battery cells 110 to 140 and the voltage of each of the battery cells 110 to 140, or the measured voltage itself of each of the battery cells 110 to 140, as a first voltage dV at each predetermined time interval.

In S406, the controller 220 may calculate a moving average of the first voltage dV of each of the battery cells 110 to 140. The moving average refers to an average of a portion of data extracted by moving a window having a predetermined size among overall data. The window is a reference period for determining data to be extracted and used among overall data. The window, for example, begins at a time that precedes by the reference period from the current time and ends at the current time. For example, when the window is one week, the controller 220 may extract voltage data acquired for the latest one-week period ending at the current time from overall voltage data.

The controller 220 may continuously calculate a moving average value of the first voltage dV of each of the battery cells 110 to 140, using the first voltage dV continuously extracted by moving the window among time-series data of the first voltage dV of each of battery cells 110 to 140. For example, the controller 220 may calculate the moving average value of the first voltage dV of each of the battery cells 110 to 140, by applying any one of a simple moving average (SMA), a weighted moving average (WMA), and an exponential moving average (EMA) to the overall data of the first voltage dV of each of the battery cells 110 to 140.

According to an embodiment, the controller 220 may apply the exponential moving average (EMA) to the overall data of the first voltage dV of each of the battery cells 110 to 140, to calculate an exponential moving average value of the first voltage dV of each of the battery cells 110 to 140. The exponential moving average is a type of weighted moving average, which uses data over all past time periods while placing a greater weight on the recent data.

The controller 220 may calculate a plurality of moving average values by applying windows with different sizes to the data of the first voltage dV of each of the battery cells 110 to 140. In an embodiment, the controller 220 may calculate a long-term moving average value and a short-term moving average value by applying a relatively long window and a relatively short window, respectively, to the overall data of the first voltage dV of each of the battery cells 110 to 140. For example, the size of the window for the long-term moving average value may include 100 seconds, and the size of the window for the short-term moving average value may include 10 seconds. For example, with the data of the first voltage dV of each of the battery cells 110 to 140, the controller 220 may calculate the long-term moving average value of the first voltage dV of each of the battery cells 110 to 140 by using the first voltage dV acquired for the latest 100 seconds preceding the calculation time, and calculate the short-term moving average value of the first voltage dV of each of the battery cells 110 to 140 by using the first voltage dV acquired for the latest 10 seconds preceding the calculation time.

In S408, the controller 220 may calculate a first deviation dV_LMA-dV_SMA, which is a deviation between the long-term moving average value dV_LMA and the short-term moving average value dV_SMA of the first voltage dV of each of the battery cells 110 to 140.

In S410, the controller 220 may continuously calculate a second deviation, which is an average value Davg of the long-term moving average value dV_LMA and the short-term moving average value dV_SMA of the first voltage dV of each of the battery cells 110 to 140, at unit time intervals.

In S412, the controller 220 may calculate a diagnosis deviation D by using the first deviation dV_LMA-dV_SMA and the average value Davg that is the second deviation. According to an embodiment, the controller 220 may calculate the difference between the first deviation dV_LMA-dV_SMA and the average value Davg that is the second deviation, as the diagnosis deviation D for each of the battery cells 110 to 140.

In S414, the controller 220 may determine whether the diagnosis deviation D of each of the battery cells 110 to 140 exceeds a threshold value.

When it is determined in S414 that the diagnosis deviation D does not exceed the threshold value, the process returns to S402 to repeat the measurement, calculation, and diagnosis process. In another embodiment, the process may not return to S402, but as needed, may return to any of the steps prior to S414 to repeat the process.

In S416, when the diagnosis deviation D of any of the battery cells 110 to 140 exceeds the threshold value, the controller 220 may determine the corresponding battery cell to be a battery cell with an abnormal voltage behavior.

The operation method of the BMS 200 according to embodiments of the present disclosure has been described. The BMS 200 of the present disclosure may accurately diagnose an abnormal battery cell by removing the noise of a deviation of long-term and short-term moving average values of a battery voltage and applying the skewness.

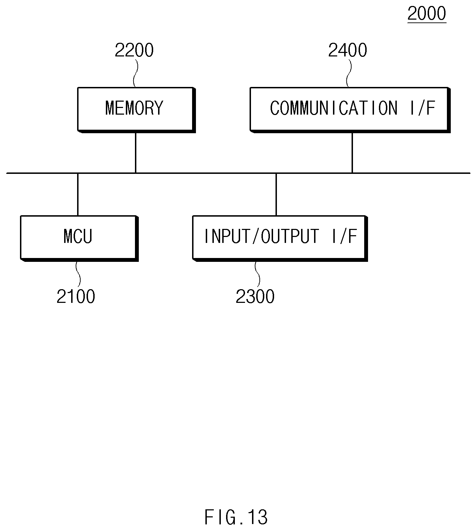

FIG. 13 is a block diagram illustrating a hardware configuration of a computing system that implements the operation method of the battery management system according to an embodiment of the present disclosure.

Referring to FIG. 13, a computing system 2000 according to an embodiment may include a mater control unit (MCU) 2100, a memory 2200, an input/output I/F 2300, and a communication I/F 2400.

The MCU 2100 may be a processor that executes various programs stored in the memory 2200, processes various data used for the programs, and executes the functions of the BMS 200 illustrated in FIG. 1.

The memory 2200 may store various programs and data for implementing the operation of the BMS 200 to diagnose an abnormal battery cell.

According to necessity, a plurality of memories 2200 may be provided. The memory 2200 may be a volatile or nonvolatile memory. As for the volatile memory, the memory 2200 may be, for example, a RAM, a DRAM, or an SRAM. As for the nonvolatile memory, the memory 2200 may be, for example, a ROM, a PROM, an EAROM, an EPROM, an EEPROM, or a flash memory. The examples of the memory 2200 may not be limited to those described above.

The input/output I/F 2300 may connect the MCU 2100 with an input device (not illustrated) such as a keyboard, a mouse, or a touch panel, and an output device (not illustrated) such as a display, in order to transmit and receive data.

The communication I/F 2400 is configured to transmit and receive various data to/from a server, and may be any of various devices capable of supporting a wired or wireless communication. For example, through the communication I/F 2400, various programs or data for the voltage measurement and the abnormality diagnosis may be transmitted and received to/from a separate external server via either a wired communication or a wireless communication.

From the foregoing, it will be appreciated that various embodiments of the present disclosure have been described herein for purposes of illustration, and that various modifications may be made without departing from the scope and spirit of the present disclosure.

Accordingly, the embodiments disclosed herein merely illustrate the technical idea of the present disclosure without limiting the scope thereof. The protection scope of the present disclosure should be interpreted based on the scope described in the following claims, and other technical concepts equivalent to the scope of the claims should be construed as being included in the protection scope of the present disclosure.

**Claims**

1. A battery management system comprising:

   a voltage measurement unit configured to measure a voltage of each of a plurality of batteries; and
   a controller in communication with the voltage measurement unit,
   wherein the controller is configured to
   control the voltage measurement unit to measure the voltage of each of the plurality of batteries at predetermined time intervals,
   calculate a first deviation, which is a deviation between a long-term moving average value and a short-term moving average value of the voltage of each of the plurality of batteries,
   calculate a second deviation, which is a deviation between a long-term moving average value and a short-term moving average value of an average voltage of the plurality of batteries,
   calculate a first diagnosis deviation, which is a difference between the first deviation and the second deviation, for each of the plurality of batteries,
   calculate a second diagnosis deviation for each of the plurality of batteries based on a reference value of the first diagnosis deviations of the first diagnosis deviations of each of the plurality of batteries obtained by multiplying the second deviation by a threshold constant, and
based on the second diagnosis deviation of each of the plurality of batteries, diagnose an abnormality of at least one battery among the plurality of batteries.

2. The battery management system according to claim 1, wherein the controller sets the reference value to a maximum value between a value obtained by multiplying the second deviation by a first threshold constant, and a second threshold constant, and
calculates the second diagnosis deviation of each of the plurality of batteries by excluding the first diagnosis deviation of each of the plurality of batteries when the first diagnosis deviation is equal to or less than the reference value.

3. The battery management system according to claim 2, wherein the controller calculates a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant.

4. The battery management system according to claim 3, wherein the controller calculates a skewness for each of the plurality of batteries by adding a minimum value of the third diagnosis deviation of each of the plurality of batteries to the third diagnosis deviation of each of the plurality of batteries, and dividing an obtained value by the third diagnosis deviation.

5. The battery management system according to claim 4, wherein the controller calculates a fourth diagnosis deviation for each of the plurality of batteries by multiplying the third diagnosis deviation of each of the plurality of batteries by the skewness.

6. The battery management system according to claim 5, wherein the controller diagnoses an abnormality of at least one battery among the plurality of batteries based on whether the fourth diagnosis deviation of each of the plurality of batteries exceeds a threshold value.

7. The battery management system according to claim 6, wherein the controller calculates a plurality of first deviations and a plurality of second deviations at unit time intervals to calculate the fourth diagnosis deviation of each of the plurality of batteries, and
when the fourth diagnosis deviation of at least one battery of the plurality of batteries exceeds the threshold value, the controller diagnoses the at least one battery as an abnormal battery.

8. A method for operating a battery management system, the method comprising:

causing a voltage measurement unit to measure a voltage of each of a plurality of batteries at predetermined time intervals;
calculating a first deviation, which is a deviation between a long-term moving average value and a short-term moving average value of the voltage of each of the plurality of batteries;
calculating a second deviation, which is a deviation between a long-term moving average value and a short-term moving average value of an average voltage of the plurality of batteries;
calculating a first diagnosis deviation, which is a difference between the first deviation and the second deviation, for each of the plurality of batteries;
calculating a second diagnosis deviation for each of the plurality of batteries based on a reference value of the first diagnosis deviations of the first diagnosis deviations of each of the plurality of batteries obtained by multiplying the second deviation by a threshold constant; and
based on the second diagnosis deviation of each of the plurality of batteries, diagnosing an abnormality of at least one battery among the plurality of batteries.

9. The method for operating a battery management system according to claim 8, wherein the calculating the second diagnosis deviation includes

setting the reference value to a maximum value between a value obtained by multiplying the second deviation by a first threshold constant, and a second threshold constant, and
calculating the second diagnosis deviation of each of the plurality of batteries by excluding the first diagnosis deviation of each of the plurality of batteries when the first diagnosis deviation is equal to or less than the reference value.

**10.** The method for operating a battery management system according to claim 9, wherein the calculating the second diagnosis deviation includes

calculating a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant.

**11.** The method for operating a battery management system according to claim 10, wherein the calculating the second diagnosis deviation includes

calculating a skewness for each of the plurality of batteries by adding a minimum value of the third diagnosis deviation of each of the plurality of batteries to the third diagnosis deviation of each of the plurality of batteries, and dividing an obtained value by the third diagnosis deviation.

**12.** The method for operating a battery management system according to claim 11, wherein the calculating the second diagnosis deviation includes

calculating a fourth diagnosis deviation for each of the plurality of batteries by multiplying the third diagnosis deviation of each of the plurality of batteries by the skewness.

**13.** The method for operating a battery management system according to claim 12, wherein the diagnosing an abnormality of at least one battery includes

diagnosing an abnormality of at least one battery among the plurality of batteries based on whether the fourth diagnosis deviation of each of the plurality of batteries exceeds a threshold value.

**14.** The method for operating a battery management system according to claim 13, wherein the diagnosing an abnormality of at least one battery includes

calculating a plurality of first deviations and a plurality of second deviations at unit time intervals to calculate the fourth diagnosis deviation of each of the plurality of batteries, and

when the fourth diagnosis deviation of at least one battery of the plurality of batteries exceeds the threshold value, diagnosing the at least one battery as an abnormal battery.

**15.** A controller for a battery management system, the controller comprising:

a memory; and

a processor coupled to the memory and configured to execute the method for operating a battery management system according to claim 8.

**16.** The controller according to claim 15, wherein the calculating the second diagnosis deviation includes

setting the reference value to a maximum value between a value obtained by multiplying the second deviation by a first threshold constant, and a second threshold constant,

calculating the second diagnosis deviation of each of the plurality of batteries by excluding the first diagnosis deviation of each of the plurality of batteries when the first diagnosis deviation is equal to or less than the reference value,

calculating a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant,

calculating a skewness for each of the plurality of batteries by adding a minimum value of the third diagnosis deviation of each of the plurality of batteries to the third diagnosis deviation of each of the plurality of batteries, and dividing an obtained value by the third diagnosis deviation,

calculating a fourth diagnosis deviation for each of the plurality of batteries by multiplying the third diagnosis deviation of each of the plurality of batteries by the skewness, and

the diagnosing an abnormality of at least one battery among the plurality of batteries comprises:

diagnosing an abnormality of at least one battery among the plurality of batteries based on whether the fourth diagnosis deviation of each of the plurality of batteries exceeds a threshold value.

**17.** A non-transitory computer-readable storage medium having stored therein a program including:

causing a voltmeter to measure a voltage of each of the plurality of batteries at predetermined time intervals;

calculating a first deviation, which is a deviation between a long-term moving average value and a short-term moving average value of the voltage of each of the plurality of batteries;

calculating a second deviation, which is a deviation between a long-term moving average value and a short-term moving average value of an average voltage of the plurality of batteries;

calculating a first diagnosis deviation, which is a difference between the first deviation and the second deviation, for each of the plurality of batteries;

calculating a second diagnosis deviation for each of the plurality of batteries based on a reference value of the first diagnosis deviations of the first diagnosis deviations of each of the plurality of batteries obtained by multiplying the second deviation by a threshold constant; and

based on the second diagnosis deviation of each of the plurality of batteries, diagnosing an abnormality of at least one battery among the plurality of batteries.

18. The non-transitory computer-readable storage medium according to claim 17, wherein the calculating the second diagnosis deviation includes

setting the reference value to a maximum value between a value obtained by multiplying the second deviation by a first threshold constant, and a second threshold constant,

calculating the second diagnosis deviation of each of the plurality of batteries by excluding the first diagnosis deviation of each of the plurality of batteries when the first diagnosis deviation is equal to or less than the reference value,

calculating a third diagnosis deviation for each of the plurality of batteries by normalizing the second diagnosis deviation of each of the plurality of batteries in which the second diagnosis deviation is divided by a maximum value between a value obtained by multiplying the second deviation by a third threshold constant, and a fourth threshold constant,

calculating a skewness for each of the plurality of batteries by adding a minimum value of the third diagnosis deviation of each of the plurality of batteries to the third diagnosis deviation of each of the plurality of batteries, and dividing an obtained value by the third diagnosis deviation,

calculating a fourth diagnosis deviation for each of the plurality of batteries by multiplying the third diagnosis deviation of each of the plurality of batteries by the skewness, and

the diagnosing an abnormality of at least one battery among the plurality of batteries comprises:

diagnosing an abnormality of at least one battery among the plurality of batteries based on whether the fourth diagnosis deviation of each of the plurality of batteries exceeds a threshold value.

FIG.1

200    220

```
┌────────────────────────────────────────────────┐
│  ┌─────────────────────┐  ┌─────────────────┐   │
│  │                     │  │   ARITHMETIC    │   │
│  │                     │  │ OPERATION UNIT  │   │
│  │                     │  │      230        │   │
│  │     VOLTAGE         │  └─────────────────┘   │
│  │   MEASUREMENT       │  ┌─────────────────┐   │
│  │     UNIT            │  │ DIAGNOSIS UNIT  │   │
│  │     210             │  │      240        │   │
│  │                     │  └─────────────────┘   │
│  │                     │  ┌─────────────────┐   │
│  │                     │  │  CONTROL UNIT   │   │
│  │                     │  │      250        │   │
│  └─────────────────────┘  └─────────────────┘   │
└────────────────────────────────────────────────┘
```

FIG.2

START

MEASURE VOLTAGE OF EACH BATTERY CELL — S102

CALCULATE LONG-TERM AND SHORT-TERM MOVING AVERAGE VALUES OF VOLTAGE OF EACH BATTERY CELL — S104

CALCULATE FIRST DEVIATION FOR EACH BATTERY CELL — S106

CALCULATE LONG-TERM AND SHORT-TERM MOVING AVERAGE VALUES OF AVERAGE VOLTAGE OF MULTIPLE BATTERY CELLS — S108

CALCULATE SECOND DEVIATION FOR AVERAGE VOLTAGE OF MULTIPLE BATTERY CELLS — S110

CALCULATE FIRST DIAGNOSIS DEVIATION (D1) FOR EACH BATTERY CELL — S112

CALCULATE SECOND DIAGNOSIS DEVIATION (D2) FOR EACH BATTERY CELL — S114

CALCULATE THIRD DIAGNOSIS DEVIATION (D3) FOR EACH BATTERY CELL — S116

CALCULATE SKEWNESS OF THIRD DIAGNOSIS DEVIATION (D3) FOR EACH BATTERY CELL — S118

CALCULATE FOURTH DIAGNOSIS DEVIATION (D4) FOR EACH BATTERY CELL — S120

FOURTH DIAGNOSIS DEVIATION (D4) OF EACH BATTERY CELL > THRESHOLD VALUE? — S122 / NO

YES

DIAGNOSE AT LEAST ONE BATTERY CELL AS ABNORMAL BATTERY CELL — S124

END

FIG.3

FIG.4

EP 4 571 333 A1

FIG.5A

EP 4 571 333 A1

FIG.5B

EP 4 571 333 A1

FIG.5C

FIG.5D

EP 4 571 333 A1

START

MEASURE VOLTAGE OF EACH BATTERY CELL — S202

CALCULATE LONG-TERM AND SHORT-TERM
MOVING AVERAGE VALUES OF VOLTAGE
OF EACH BATTERY CELL — S204

CALCULATE FIRST DEVIATION FOR EACH BATTERY CELL — S206

CALCULATE LONG-TERM AND SHORT-TERM
MOVING AVERAGE VALUES OF AVERAGE
VOLTAGE OF MULTIPLE BATTERY CELLS — S208

CALCULATE SECOND DEVIATION FOR AVERAGE
VOLTAGE OF MULTIPLE BATTERY CELLS — S210

CALCULATE FIRST DIAGNOSIS
DEVIATION (D1) FOR EACH BATTERY CELL — S212

CALCULATE SECOND DIAGNOSIS
DEVIATION (D2) FOR EACH BATTERY CELL — S214

SECOND DIAGNOSIS
DEVIATION (D2) OF EACH BATTERY CELL
>THRESHOLD VALUE? — S216      NO

YES

DIAGNOSE AT LEAST ONE BATTERY CELL
AS ABNORMAL BATTERY CELL — S218

END

FIG.6

START

MEASURE VOLTAGE OF EACH BATTERY CELL ——S302

CALCULATE FIRST VOLTAGE (dV) OF EACH BATTERY CELL ——S304

CALCULATE LONG-TERM AND SHORT-TERM
MOVING AVERAGE VALUES OF
FIRST VOLTAGE OF EACH BATTERY CELL ——S306

CALCULATE FIRST DEVIATION
FOR FIRST VOLTAGE OF EACH BATTERY CELL ——S308

CALCULATE SECOND DEVIATION FOR EACH BATTERY CELL ——S310

CALCULATE FIRST DIAGNOSIS
DEVIATION (D1) FOR EACH BATTERY CELL ——S312

CALCULATE SECOND DIAGNOSIS
DEVIATION (D2) FOR EACH BATTERY CELL ——S314

CALCULATE THIRD DIAGNOSIS
DEVIATION (D3) FOR EACH BATTERY CELL ——S316

CALCULATE SKEWNESS OF THIRD DIAGNOSIS
DEVIATION (D3) FOR EACH BATTERY CELL ——S318

CALCULATE FOURTH DIAGNOSIS
DEVIATION (D4) FOR EACH BATTERY CELL ——S320

FOURTH DIAGNOSIS
DEVIATION (D4) OF EACH BATTERY CELL
> THRESHOLD VALUE? — S322 — NO

YES

DIAGNOSE AT LEAST ONE BATTERY ——S324

END

FIG.7

FIG.8A

FIG.8B

EP 4 571 333 A1

FIG.9A

EP 4 571 333 A1

FIG.9B

EP 4 571 333 A1

FIG.10A

EP 4 571 333 A1

FIG.10B

EP 4 571 333 A1

FIG.11A

FIG.11B

EP 4 571 333 A1

START

MEASURE VOLTAGE OF EACH BATTERY CELL — S402

CALCULATE FIRST VOLTAGE (dV)
OF EACH BATTERY CELL — S404

CALCULATE LONG-TERM AND SHORT-TERM
MOVING AVERAGE VALUES OF
FIRST VOLTAGE OF EACH BATTERY CELL — S406

CALCULATE FIRST DEVIATION FOR
FIRST VOLTAGE OF EACH BATTERY CELL — S408

CALCULATE SECOND DEVIATION
FOR EACH BATTERY CELL — S410

CALCULATE DIAGNOSIS DEVIATION (D)
FOR EACH BATTERY CELL — S412

S414
DIAGNOSIS
DEVIATION (D) OF EACH BATTERY CELL
> THRESHOLD VALUE?      NO

YES

DIAGNOSE AT LEAST ONE BATTERY CELL
AS ABNORMAL BATTERY CELL — S416

END

FIG.12

2000

2200                                    2400

| MEMORY |        | COMMUNICATION I/F |

| MCU |        | INPUT/OUTPUT I/F |

2100                     2300

FIG.13

## INTERNATIONAL SEARCH REPORT

| International application No. |
| --- |
| **PCT/KR2023/014493** |

| A. | CLASSIFICATION OF SUBJECT MATTER |
| --- | --- |

**G01R 31/36**(2006.01)i; **G01R 31/392**(2019.01)i; **G01R 31/385**(2019.01)i; **G01R 31/396**(2019.01)i; **G01R 19/00**(2006.01)i; **G01R 19/30**(2006.01)i; **G01R 19/10**(2006.01)i; **B60L 58/10**(2019.01)i; **G01R 31/3835**(2019.01)i

According to International Patent Classification (IPC) or to both national classification and IPC

| B. | FIELDS SEARCHED |
| --- | --- |

Minimum documentation searched (classification system followed by classification symbols)

G01R 31/36(2006.01); G01R 19/00(2006.01); G01R 31/382(2019.01); G01R 31/3842(2019.01); G01R 31/388(2019.01); H01M 10/42(2006.01); H01M 4/86(2006.01); H01M 8/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 편차(deviation), 이동평균(moving average), 이상(abnormality), 진단(diagnosis)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2022-0074797 A (LG ENERGY SOLUTION, LTD.) 03 June 2022 (2022-06-03)<br>See claims 1-3. | 1-18 |
| A | KR 10-1349022 B1 (HYUNDAI MOTOR COMPANY) 09 January 2014 (2014-01-09)<br>See claims 1-3. | 1-18 |
| A | WO 2021-186512 A1 (KABUSHIKI KAISHA TOSHIBA) 23 September 2021 (2021-09-23)<br>See claims 1-6. | 1-18 |
| A | CN 114518539 A (BEIJING TRAFFIC UNIVERSITY) 20 May 2022 (2022-05-20)<br>See entire document. | 1-18 |
| A | JP 2002-334722 A (MATSUSHITA ELECTRIC IND. CO., LTD. et al.) 22 November 2002 (2002-11-22)<br>See entire document. | 1-18 |

☐ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **02 January 2024** | **02 January 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/014493**

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | JP | 2023-519949 | A | 15 May 2023 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-1349022 | B1 | 09 January 2014 | KR | 10-2012-0096615 | A | 31 August 2012 |
| WO | 2021-186512 | A1 | 23 September 2021 | EP | 4123322 | A1 | 25 January 2023 |
| | | | | JP | 7214884 | B2 | 30 January 2023 |
| | | | | WO | 2021-186512 | A1 | 23 September 2021 |
| CN | 114518539 | A | 20 May 2022 | | None | | |
| JP | 2002-334722 | A | 22 November 2002 | | None | | |

Form PCT/ISA/210 (patent family annex) (July 2022)

**EP 4 571 333 A1**

**Patent documents cited in the description**

- KR 1020220120366
- KR 1020230058253
- KR 1020230126472